# EUROPEAN PATENT APPLICATION

(11) **EP 3 424 702 A1**
(43) Date of publication of application: **09.01.2019**
(21) Application number: 17760050.9
(22) Date of filing: 28.02.2017
(51) Int. Cl.: B32B 7/02, B32B 9/00, B32B 27/20, C08K 9/04, C08L 63/02, H01L 23/36, H01L 23/373

(54) **LAMINATE, ELECTRONIC DEVICE, AND PRODUCTION METHOD FOR LAMINATE**

(30) Priority: 02.03.2016 JP 2016040522
(71) Applicant: JNC Corporation, Chiyoda-ku Tokyo 100-8105 (JP); Osaka Research Institute of Industrial Science and Technology, Izumi-shi, Osaka 594-1157 (JP)
(72) Inventor: FUJIWARA,Takeshi, Ichihara-shi Chiba 290-8551 (JP); INAGAKI, Jyunichi, Ichihara-shi Chiba 290-8551 (JP); AGARI, Yasuyuki, Osaka-shi Osaka 536-8553 (JP); HIRANO, Hiroshi, Osaka-shi Osaka 536-8553 (JP); KADOTA, Joji, Osaka-shi Osaka 536-8553 (JP); OKADA, Akinori, Osaka-shi Osaka 536-8553 (JP)
(74) Representative: Becker Kurig Straus
(86) International application number: PCT/JP2017/008026
(87) International publication number: WO 2017/150586

(57) **Abstract**

The present invention is a laminate: with which differences in the thermal expansion coefficient at interfaces between different materials in the interior of a semiconductor element or the like can be kept small; which has high heat resistance; and which has high thermal conductivity. This laminate is provided with at least two layers of thermal expansion-controlling members, the thermal expansion-controlling members including a thermally conductive first inorganic filler joined to one end of a first coupling agent, and a thermally conductive second inorganic filler joined to one end of a second coupling agent; the other end of the first coupling agent and the other end of the second coupling agent are respectively joined to a polymerizable compound, or joined to one another; and the thermal expansion-controlling members have thermal expansion coefficients that are respectively different.

## Description

### [Technical Field]

The present invention relates to a laminate that can control thermal expansion used for an electronic instrument such as an electronic substrate, and particularly, to a laminate which has both processability of a resin and a high heat resistance of 250 °C or higher, and additionally, which can efficiently transfer and conduct heat generated in an electronic instrument and thus can dissipate heat.

### [Background Art]

In recent years, in semiconductor devices for power control of electric trains, hybrid vehicles, and electric vehicles, operation temperatures thereof have risen due to use of wide gap semiconductors. In silicon carbide (SiC) semiconductors and the like which have been particularly focused upon, since the operation temperature is 200 °C or higher, a packaging material therefor needs to have a high heat resistance of 250 °C or higher. In addition, due to the rise in the operation temperature, thermal distortion may occur due to a difference between thermal expansion coefficients of materials used in a package, and there is also a problem of a reduced lifespan due to peeling off of a wiring or the like.

As a method of solving such a heat resistance problem, highly thermally conductive ceramic substrates such as aluminum nitride and silicon nitride and highly heat resistant organic resins and silicone resins combined with inorganic fillers for improving thermal conductivity have been developed and particularly the development of high heat resistance resins such as oxazine resins and high heat resistance silicone resins have progressed. In Patent Literature 1, a polybenzoxazine-modified bismaleimide resin having excellent heat resistance is disclosed. However, compounds that exhibit sufficient heat resistance and durability have not yet been utilized, and thus the development of materials with higher heat resistance has been performed.

As another method of solving a heat resistance problem of a member, there is a method in which thermal conductivity is improved, unevenness in temperature is reduced, and as a result, localized high temperatures are reduced. In addition, it can also be expected that there will be an effect in which, when the thermal conductivity of a member is high, a temperature of a part in contact with the member will be unlikely to rise. Generally, the introduction of many cyclic structures into a main chain of molecules in order to increase thermal conductivity of a resin component has been examined. In addition, it is known that high linearity of molecular chains is preferred in order to improve thermal conductivity of such resins. Examples of a compound having many cyclic structures and linearity include a liquid crystal compound.

In Patent Literature 2, as a method of improving the thermal conductivity of a resin, a method in which a liquid crystal composition containing a liquid crystal compound having a polymerization group at both ends is alignment-controlled using an alignment control additive, a rubbing treatment method, or the like, polymerization is performed in a state in which the alignment state is maintained, and thus a resin film having high thermal conductivity is obtained is disclosed.

### [Citation List]

### [Patent Literature]

[Patent Literature 1]
   Japanese Unexamined Patent Application Publication No. 2012-97207
[Patent Literature 2]
   Japanese Unexamined Patent Application Publication No. 2006-265527

### [Summary of Invention]

### [Technical Problem]

As described above, for a substrate of a semiconductor device used at high temperatures, a material having high heat resistance and thermal conductivity is desirable. In addition, a thick copper electrode is laminated on a substrate in order for high power flow to a semiconductor, but large stress is applied to an adhesive surface due to a difference between thermal expansion coefficients of the substrate and copper, and there is also a problem of the electrode peeling off. However, if a difference in the thermal expansion coefficient of the adhesive surface can be made smaller, it is possible to prevent the problem of peeling off.

Thus, an objective of the present invention is to provide a laminate which can reduce a difference between thermal expansion coefficients at an interface between different materials such as copper and SiC in a semiconductor device, and has high heat resistance and also has high thermal conductivity.

### [Solution to Problem]

The inventors found that, in combining an organic material and an inorganic material, when inorganic materials are connected to each other rather than adding an inorganic material to a resin, that is, when inorganic materials are directly bonded to each other using a coupling agent and a bifunctional or higher polymerizable compound (refer to FIG. 2), or when inorganic materials are directly bonded to each other using a coupling agent (refer to FIGs. 3 and 4), it is possible to form a thermal expansion-controlling member which has very high heat resistance (a glass transition temperature and a decomposition temperature) of 250 °C or higher and has high thermal conductivity, and the thermal expansion coefficient can be changed from positive to negative according to compositional proportions of inorganic materials contained, and completed the present invention.

A laminate according to a first aspect of the present invention is a laminate including at least two layers of a thermal expansion-controlling member: the thermal expansion-controlling member including a thermally conductive first inorganic filler that is bonded to one end of a first coupling agent; and a thermally conductive second inorganic filler that is bonded to one end of a second coupling agent.

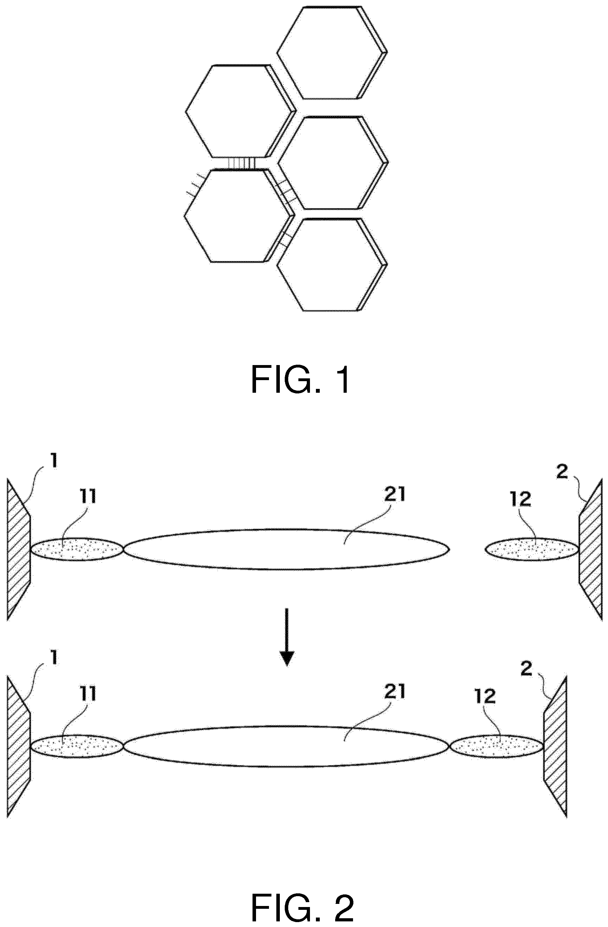

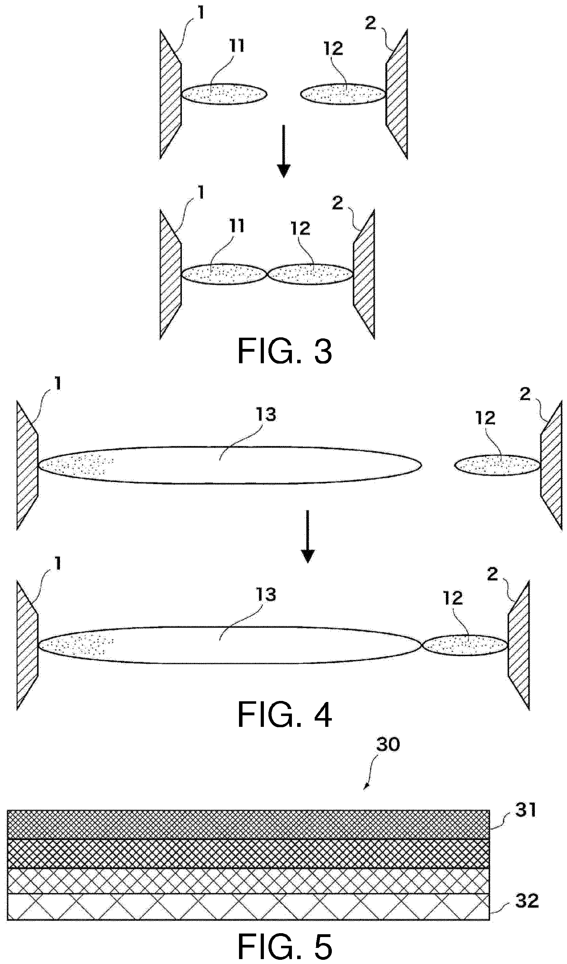

In the thermal expansion-controlling member, the other end of the first coupling agent and the other end of the second coupling agent are bonded to a polymerizable compound, for example, as shown in FIG. 2, or, in the thermal expansion-controlling member, the other end of the first coupling agent and the other end of the second coupling agent are bonded to each other, for example, as shown in FIG. 3.

The thermal expansion-controlling members each have different thermal expansion coefficients.
"One end" and "the other end" may be tips or ends in a shape of a molecule and may or may not be both ends of the long side of a molecule.

In such a configuration, the thermal expansion-controlling member can be formed by bonding inorganic fillers using a coupling agent and a polymerizable compound. Therefore, it is possible to directly propagate phonons which are a main element for thermal conduction, and the thermal expansion-controlling member can have very high thermal conductivity not only in the horizontal direction but also in the thickness direction. In addition, when a laminate of thermal expansion-controlling members having different arbitrary thermal expansion coefficients is formed and is disposed at an interface between materials having different thermal expansion coefficients, it is possible to reduce a difference between thermal expansion coefficients at the interface.

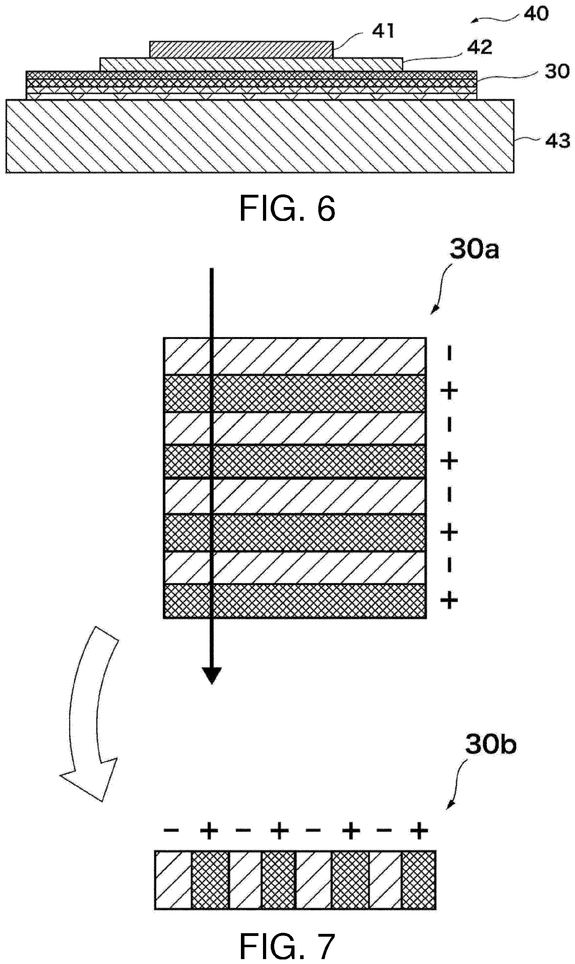

A laminate according to a second aspect of the present invention, for example, is a laminate (30a, 30b) in which each layer of the thermal expansion-controlling member layers is laminated in a thickness direction or a horizontal direction as shown in FIG. 7, in the laminate according to the first aspect of the present invention.

In such a configuration, it is possible to alleviate distortion due to a difference between thermal expansion coefficients not only in the thickness direction but also in the horizontal direction.

In a laminate according to a third aspect of the present invention, the first inorganic filler and the second inorganic filler are a nitride, a metal oxide, a silicate compound, or a carbon material, in the laminate according to the first aspect or the second aspect of the present invention.

In such a configuration, the thermal expansion-controlling member constituting the laminate can include a more preferable compound as an inorganic filler.

In a laminate according to a fourth aspect of the present invention, the first inorganic filler and the second inorganic filler are at least one selected from the group consisting of boron nitride, aluminum nitride, boron carbide, boron carbonitride, graphite, carbon fibers, carbon nanotubes, alumina, and cordierite, in the laminate according to the third aspect of the present invention.

In such a configuration, it is possible to obtain a laminate including a thermal expansion-controlling member having an inorganic filler with a high thermal conductivity, and having a very small or negative thermal expansion coefficient.

In a laminate according to a fifth aspect of the present invention, the thermal expansion-controlling member further includes a third inorganic filler having a thermal expansion coefficient different from those of the first inorganic filler and the second inorganic filler, in the laminate according to any one of the first to fourth aspects of the present invention.

In such a configuration, when the first inorganic filler and the second inorganic filler have a two-dimensional plate shape or a one-dimensional linear shape, if only the first inorganic filler and the second inorganic filler are combined with each other, the physical properties of the combined heat dissipation member composition includes high anisotropy. Adding the third inorganic filler has an advantage that the orientation of the first and second inorganic fillers is relaxed and the anisotropy is reduced. In addition, when the thermal expansion coefficient of first and second inorganic fillers is very small or negative, if a third inorganic filler having a positive thermal expansion coefficient is added, it is possible to perform accurate control according to the fraction incorporated such that a negative value for the thermal expansion coefficient becomes a positive value. Although there are no limitation on inorganic fillers which can be used for the third inorganic filler, an inorganic filler having a high thermal conductivity is desirable.

In a laminate according to a sixth aspect of the present invention, the thermal expansion-controlling member further includes an organic compound or a polymer compound that is not bonded to the first inorganic filler or the second inorganic filler, in the laminate according to any one of the first to fifth aspects of the present invention.

In such a configuration, in the thermal expansion-controlling member obtained by directly connecting the first and second inorganic fillers and performing curing, when the particle size of the filler is increased in order to improve thermal conductivity, the porosity increases accordingly. When voids are filled with a compound that is not bonded, it is possible to improve thermal conductivity and water vapor barrier properties.

In a laminate according to a seventh aspect of the present invention, the polymerizable compound before bonding is at least one of bifunctional or higher polymerizable liquid crystal compounds represented by the following Formula (1-1), in the laminate according to any one of the first to sixth aspects of the present invention.

R^{a}-Z-(A-Z)ₘ-R^{a} ... (1-1)

[in Formula (1-1),
R^{a} independently represents a functional group that can be bonded to a functional group of the other end of a first coupling agent and a second coupling agent;
A is 1,4-cyclohexylene, 1,4-cyclohexenylene, 1,4-phenylene, naphthalene-2,6-diyl, tetrahydronaphthalene-2,6-diyl, fluorene-2,7-diyl, bicyclo[2.2.2]oct-1,4-diyl, or bicyclo[3.1.0]hex-3,6-diyl,
in these rings, any -CH₂- is optionally substituted with -O-, any -CH= is optionally substituted with -N=, and any hydrogen atom is optionally substituted with a halogen atom, an alkyl group having 1 to 10 carbon atoms, or an alkyl halide having 1 to 10 carbon atoms,
in the alkyl group, any -CH₂- is optionally substituted with -O-, -CO-, -COO-, -OCO-, -CH=CH-, or -C=C-;
Z independently represents a single bond or an alkylene group having 1 to 20 carbon atoms,
in the alkylene group, any -CH₂- is optionally substituted with -O-, -S-, -CO-, -COO-, -OCO-, -CH=CH-, -CF=CF-, -CH=N-, -N=CH-, -N=N-, -N(O)=N-, or -C=C-, and any hydrogen atom is optionally substituted with a halogen atom;
m is an integer of 1 to 6.]

In such a configuration, the thermal expansion-controlling member constituting the laminate can contain a polymerizable liquid crystal compound as a polymerizable compound. These compounds are thermosetting and can be cured without being affected by an amount of the filler, and also have excellent heat resistance. In addition, since the molecular structure has symmetry and linearity, these properties are advantageous for conduction of phonons.

In a laminate according to an eighth aspect of the present invention, in Formula (1-1), A is 1,4-cyclohexylene, 1,4-cyclohexylene in which any hydrogen atom is substituted with a halogen atom, 1,4-phenylene, 1,4-phenylene in which any hydrogen atom is substituted with a halogen atom or a methyl group, fluorene-2,7-diyl, or fluorene-2,7-diyl in which any hydrogen atom is substituted with a halogen atom or a methyl group, in the laminate according to the seventh aspect of the present invention.

In such a configuration, the thermal expansion-controlling member constituting the laminate can contain a more preferable compound as a polymerizable liquid crystal compound. These compounds are thought to have higher molecular linearity and more advantageous phonon conduction.

In a laminate according to a ninth aspect of the present invention, in Formula (1-1), Z is a single bond, -(CH2)a-, -O(CH₂)ₐ-, -(CH2)aO-, -O(CH₂)ₐO-, -CH=CH-, -C≡C-, -COO-, -OCO-, -CH=CH-COO-, -OCO-CH=CH-, -CH₂CH₂-COO-, -OCO-CH₂CH₂-, -CH=N-, -N=CH-, -N=N-, -OCF₂- or -CF₂O-, and a is an integer of 1 to 20, in the laminate according to the seventh aspect or eighth aspect of the present invention.

In such a configuration, the thermal expansion-controlling member constituting the laminate can contain a particularly preferable compound as a polymerizable liquid crystal compound. These compounds are preferable because they have excellent physical properties, ease of production, and ease of handling.

In a laminate according to a tenth aspect of the present invention, in Formula (1-1), R^{a} independently represents polymerizable groups having the following Formulae (2-1) and (2-2), cyclohexene oxide, phthalic anhydride, or succinic anhydride, in the laminate according to any one of the seventh to ninth aspects of the present invention.

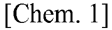

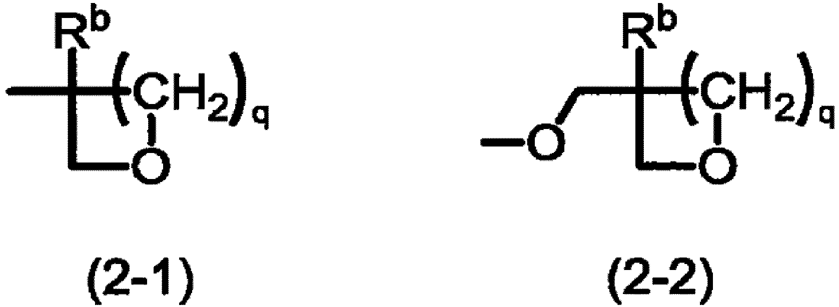

[in Formulae (2-1) and (2-2), R^{b} is a hydrogen atom, a halogen atom, -CF₃, or an alkyl group having 1 to 5 carbon atoms, and q is 0 or 1.]

In such a configuration, a bond between a silane coupling agent having favorable heat resistance and high thermal conductivity and organic molecules can be formed. In addition, when heat resistance is particularly important, a configuration having a structure having high heat resistance such as an imide bond and an amide bond can be appropriately selected even if thermal conductivity is slightly lowered.

An electronic instrument according to an eleventh aspect of the present invention includes the laminate according to any one of the first to tenth aspects of the present invention and an electronic device including a heating unit. The laminate is disposed on the electronic device such that it comes in contact with the heating unit.

In such a configuration, according to the thermal expansion-controlling member having high thermal conductivity, heat generated in the electronic device can conduct efficiently. In addition, a thermal expansion coefficient in the planar direction is set to be close to a thermal expansion coefficient of a copper wiring attached to the thermal expansion-controlling member or a semiconductor device of such as silicon, silicon nitride, or the like, and thus a device that does not easily peel off due to a heat cycle can be produced.

A method of producing a laminate according to a twelfth aspect of the present invention includes a coating process A of applying a composition A including a thermally conductive first inorganic filler bonded to one end of a first coupling agent and a thermally conductive second inorganic filler bonded to one end of a second coupling agent; a coating process B of applying a composition B of which a compositional ratio between inorganic fillers is different from the composition A; a curing process of curing a coating of the composition A and a coating of the composition B; and a laminating process of laminating the cured coating of the composition A and the cured coating of the composition B.

According to the curing process, the other end of the first coupling agent and the other end of the second coupling agent are bonded to a bifunctional or higher polymerizable compound, or the other end of the first coupling agent and the other end of the second coupling agent are bonded to each other.

In such a configuration, a method of producing a thermal expansion-controlling member in which inorganic fillers are bonded to each other using a coupling agent and a polymerizable compound is provided.

Here, the coating of the composition A is a coating obtained by applying the composition A and the coating of the composition B is a coating obtained by applying the composition B.

### [Advantageous Effects of Invention]

The thermal expansion-controlling member of the present invention has very high thermal conductivity and controllability of a thermal expansion coefficient. In addition, the thermal expansion-controlling member has excellent properties such as chemical stability, heat resistance, hardness, and mechanical strength. The thermal expansion-controlling member is suitable for, for example, a heat dissipation board, a heat dissipation plate (planar heatsink), a heat dissipation sheet, a heat dissipation coating, and a heat dissipation adhesive. In addition, when a laminate is formed of thermal expansion-controlling members with different thermal expansion coefficients, it is possible to reduce a difference between thermal expansion coefficients at an interface between different materials.

### [Brief Description of Drawings]

FIG. 1 is a conceptual diagram showing bonding of inorganic fillers using boron nitride as an example in a thermal expansion-controlling member of the present invention.
FIG. 2 is a conceptual diagram showing a state in which, according to a curing treatment of a composition for a thermal expansion-controlling member, the other end of a polymerizable compound 21 bonded to a first coupling agent 11 is bonded to the other end of a second coupling agent 12.
FIG. 3 is a conceptual diagram showing a state in which, according to a curing treatment of a composition for a thermal expansion-controlling member, the other end of the first coupling agent 11 is bonded to the other end of the second coupling agent 12.
FIG. 4 is a conceptual diagram showing a state in which, according to a curing treatment of a composition for a thermal expansion-controlling member, the other end of a first coupling agent 13 is bonded to the other end of the second coupling agent 12.
FIG. 5 is a diagram showing a layer structure of a laminate 30 in which a thermal expansion coefficient continuously changes.
FIG. 6 is a diagram showing a configuration in which the laminate 30 is disposed between a copper wiring 42 and an aluminum heat sink 43 of an electronic substrate 40 including a semiconductor device 41.
FIG. 7 is a conceptual diagram showing a case in which a laminate 30b laminated in a horizontal direction is formed from a laminate 30a laminated in a thickness direction such that thermal expansion coefficients are positive (+), negative (-), positive, negative, positive, negative...

### [Description of Embodiments]

Priority is claimed on Japanese Patent Application No. 2016-040522, filed March 2, 2016, the content of which is incorporated herein by reference. The present invention will be more completely understood from the following detailed description. Further scope for application of the present invention will be clearly understood from the following detailed description. It should be understood, however, that the detailed description and the specific examples are preferred embodiments of the present invention and are set forth for the purpose of illustration only. From the detailed description, various modifications and alternations within the spirit and scope of the present invention will be clearly understood by those skilled in the art. The applicants do not intend to present any of described embodiments to the public and among alternations and alternative proposals, those that are not explicitly included in the scope of claims are parts of the invention under the doctrine of equivalents.

Embodiments of the present invention will be described below with reference to the drawings. Here, in the drawings, the same or corresponding parts will be denoted with the same or similar reference numerals, and redundant descriptions will be omitted. In addition, the present invention is not limited to the following embodiments.

The terms used in this specification are as follows.

A "liquid crystal compound" or a "liquid crystalline compound" is a compound that exhibits a liquid crystal phase such as a nematic phase or a smectic phase.

When it is stated that "any -CH₂- in an alkyl group is optionally substituted with -O-" or "any -CH₂CH₂- is optionally substituted with -CH=CH-," this means the following for example. For example, examples of groups in which any -CH₂- in C₄H₉-is substituted with -O- or -CH=CH- include C₃H₇O-, CH₃-O-(CH₂)₂-, and CH₃-O-CH₂-O-. Similarly, examples of groups in which any -CH₂CH₂- in C₅H₁₁- is substituted with -CH=CH- include H₂C=CH-(CH₂)₃-, and CH₃-CH=CH-(CH₂)₂-, and examples of groups in which any -CH₂- is substituted with -O- include CH₃-CH=CH-CH₂-O-. Thus, the term "any" means "at least one selected without distinction." Here, in consideration of stability of a compound, CH₃-O-CH₂-O- in which oxygen and oxygen are not adjacent to each other is preferable to CH₃-O-O-CH₂- in which oxygen and oxygen are adjacent to each other.

In addition, regarding a ring A, when it is stated that "any hydrogen atom is optionally substituted with a halogen, an alkyl group having 1 to 10 carbon atoms, or an alkyl halide having 1 to 10 carbon atoms," this means a case in which, for example, at least one of hydrogen atoms at the 2, 3, 5, and 6 positions on 1,4-phenylene is substituted with a substituent such as a fluorine atom or a methyl atom and a case in which a substituent is "an alkyl halide having 1 to 10 carbon atoms" includes examples such as 2-fluoroethyl and 3-fluoro-5-chlorohexyl.

"Compound (1-1)" means a bifunctional or higher polymerizable liquid crystal compound represented by the following Formula (1-1) to be described below and may also mean at least one compound represented by the following Formula (1-1). When one Compound (1-1) includes a plurality of A, any two A may be the same as or different from each other. When a plurality of Compounds (1-1) include A, any two A may be the same as or different from each other. This rule also applies to other symbols and groups such as R^{a} and Z.

### [Laminate]

A laminate according to a first embodiment of the present invention is obtained by curing a composition for a thermal expansion-controlling member and laminating at least two thermal expansion-controlling member layers which are cured products thereof. When proportions and types of inorganic fillers contained in the composition for a thermal expansion-controlling member are changed, a thermal expansion coefficient of the thermal expansion-controlling member can be arbitrarily changed. Therefore, when a laminate of thermal expansion-controlling members with different thermal expansion coefficients is formed using the composition for a thermal expansion-controlling member, it is possible to form layers with graded thermal expansion coefficients. When this laminate is disposed at an interface between materials with different thermal expansion coefficients, it is possible to reduce a difference between thermal expansion coefficients at the interface and it is possible to prevent a problem (such as cracks) caused by a difference between thermal expansion coefficients. First, the composition for a thermal expansion-controlling member will be described.

### <<Composition for a thermal expansion-controlling member>>

The composition for a thermal expansion-controlling member (hereinafter referred to as a composition) is a composition that can form a thermal expansion-controlling member by inorganic fillers being directly bonded using a coupling agent and a bifunctional or higher polymerizable compound according to a curing treatment. FIG. 1 shows an example in which boron nitride is used as an inorganic filler. When boron nitride (h-BN) is treated with a coupling agent, since boron nitride has no reactive group on the plane of particles, a coupling agent is bonded only to surrounding materials. Boron nitride treated with a coupling agent can form a bond with a bifunctional or higher polymerizable compound. Therefore, when coupling agents bonded to boron nitride are connected using a bifunctional or higher polymerizable compound (refer to FIG. 2), boron nitride molecules are bonded to each other as shown in FIG. 1.

In this manner, when inorganic fillers are bonded to each other using a coupling agent and a bifunctional or higher polymerizable compound, since phonons can be directly propagated, the cured thermal expansion-controlling member has very high thermal conductivity, and it is possible to produce a composite material in which a thermal expansion coefficient of an inorganic component is directly reflected.

For example, as shown in FIG. 2, the composition for a thermal expansion-controlling member includes a thermally conductive first inorganic filler 1 bonded to one end of a first coupling agent 11 and a thermally conductive second inorganic filler 2 bonded to one end of a second coupling agent 12. In addition, one end of a polymerizable compound 21 is bonded to the other end of the first coupling agent 11. However, the other end of the polymerizable compound 21 is not bonded to the other end of the second coupling agent 12.

As shown in FIG. 2, when the composition for a thermal expansion-controlling member is cured, the other end of the second coupling agent 12 is bonded to the other end of the polymerizable compound 21. In this manner, a bond between inorganic fillers is formed. Here, realization of such a bond between the inorganic fillers is important in the present invention, and before the silane coupling agent is bonded to the inorganic filler, a silane coupling agent and a bifunctional or higher polymerizable compound may be reacted with each other using an organic synthetic technique in advance.

### <Bifunctional or higher polymerizable compound>

As the bifunctional or higher polymerizable compound bonded to the first coupling agent, a bifunctional or higher polymerizable liquid crystal compound (hereinafter simply referred to as a "polymerizable liquid crystal compound" in some cases) is preferably used.

As the polymerizable liquid crystal compound, a liquid crystal compound represented by the following Formula (1-1) is preferable, which has a liquid crystal framework and a polymerizable group, and has high polymerization reactivity, a wide temperature range of a liquid crystal phase, favorable miscibility, and the like. When Compound (1-1) is mixed with other liquid crystal compounds or polymerizable compounds, the mixture is likely to be uniform.

R^{a}-Z-(A-Z)ₘ-R^{a} (1-1)

When a terminal group R^{a}, a ring structure A and a bond group Z of Compound (1-1) are appropriately selected, it is possible to arbitrarily adjust physical properties such as a liquid crystal phase exhibition range. Effects of types of the terminal group R^{a}, the ring structure A and the bond group Z on physical properties of Compound (1-1) and preferable examples thereof will be described below.

### • Terminal group R^{a}

The terminal group R^{a} may independently represents a functional group that can be bonded to a functional group of the other end of the first coupling agent and the second coupling agent.

For example, polymerizable groups represented by the following Formulae (2-1) and (2-2), cyclohexene oxide, phthalic anhydride, and succinic anhydride can be exemplified, but the present invention is not limited thereto.

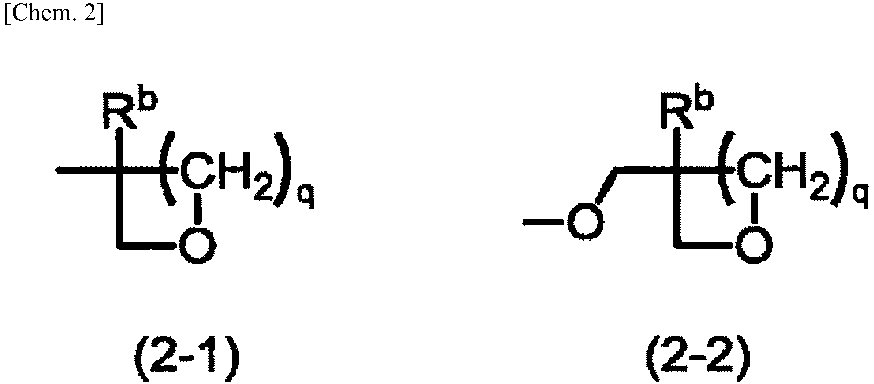

[in Formulae (2-1) and (2-2), R^{b} is a hydrogen atom, a halogen atom, -CF₃, or an alkyl group having 1 to 5 carbon atoms, and q is 0 or 1]

In addition, examples of a combination of functional groups that form a bond between the terminal group R^{a} and the coupling agent include a combination of an oxiranyl group and an amino group, a combination of vinyl groups, a combination of methacryloxy groups, a combination of a carboxy or carboxylic acid anhydride residue and an amine group, and a combination of imidazole and an oxiranyl group, but the present invention is not limited thereto. A combination with high heat resistance is more preferable.

### • Ring structure A

When at least one ring in the ring structure A of Compound (1-1) is 1,4-phenylene, an orientational order parameter and magnetization anisotropy are large. In addition, when at least two rings are 1,4-phenylene, a temperature range of a liquid crystal phase is wide and a clearing point is also high. When at least one hydrogen atom on the 1,4-phenylene ring is substituted with a cyano group, a halogen atom, -CF₃ or -OCF₃, dielectric anisotropy is large. In addition, when at least two rings are 1,4-cyclohexylene, a clearing point is high and the viscosity is small.

Examples of a preferable A include 1,4-cyclohexylene, 1,4-cyclohexenylene, 2,2-difluoro-1,4-cyclohexylene, 1,3-dioxane-2,5-diyl, 1,4-phenylene, 2-fluoro-1,4-phenylene, 2,3-difluoro-1,4-phenylene, 2,5-difluoro-1,4-phenylene, 2,6-difluoro-1,4-phenylene, 2,3,5-trifluoro-1,4-phenylene, pyridine-2,5-diyl, 3-fluoropyridine-2,5-diyl, pyrimidine-2,5-diyl, pyridazine-3,6-diyl, naphthalene-2,6-diyl, tetrahydronaphthalene-2,6-diyl, fluorene-2,7-diyl, 9-methyl fluorene-2,7-diyl, 9,9-dimethyl fluorene-2,7-diyl, 9-ethyl fluorene-2,7-diyl, 9-fluoro fluorene-2,7-diyl, and 9,9-difluoro fluorene-2,7-diyl.

Regarding the configuration of 1,4-cyclohexylene and 1,3-dioxane-2,5-diyl, a trans configuration is preferable to a cis configuration. Since 2-fluoro-1,4-phenylene and 3-fluoro-1,4-phenylene are structurally the same, the latter is not shown. This rule also applies to a relationship between 2,5-difluoro-1,4-phenylene and 3,6-difluoro-1,4-phenylene.

Examples of a more preferable A include 1,4-cyclohexylene, 1,4-cyclohexenylene, 1,3-dioxane-2,5-diyl, 1,4-phenylene, 2-fluoro-1,4-phenylene, 2,3-difluoro-1,4-phenylene, 2,5-difluoro-1,4-phenylene, and 2,6-difluoro-1,4-phenylene. Examples of a particularly preferable A include 1,4-cyclohexylene and 1,4-phenylene.

### • Bond group Z

When the bond group Z of Compound (1-1) is a single bond, -(CH₂)₂-, -CH₂O-, -OCH₂-, -CF₂O-, -OCF₂-, -CH=CH-, -CF=CF- or -(CH₂)₄-, and particularly, is a single bond, -(CH₂)₂-, -CF₂O-, -OCF₂-, -CH=CH- or -(CH₂)₄-, the viscosity is low. In addition, when the bond group Z is -CH=CH-, -CH=N-, -N=CH-, -N=N- or -CF=CF-, a temperature range of a liquid crystal phase is wide. In addition, when the bond group Z is an alkyl group having about 4 to 10 carbon atoms, a melting point is lowered.

Examples of a preferable Z include a single bond, -(CH₂)₂-, -(CF₂)₂-, -COO-, -OCO-, -CH₂O-, -OCH₂-, -CF₂O-, -OCF₂-, -CH=CH-, -CF=CF-, -C=C-, -(CH₂)₄-, -(CH₂)₃O-, -O(CH₂)₃-, -(CH₂)₂COO-, -OCO(CH₂)₂-, -CH=CH-COO-, and -OCO-CH=CH-.

Examples of a more preferable Z include a single bond, -(CH₂)₂-, -COO-, -OCO-, -CH₂O-, -OCH₂-, -CF₂O-, -OCF₂-, -CH=CH-, and -C=C-. Examples of a particularly preferable Z include a single bond, -(CH₂)₂-, -COO- and -OCO-.

When Compound (1-1) has more rings, since it is not easily softened even at high temperatures, it is preferable as a heat dissipation material. However, when a softening temperature is higher than a polymerization temperature, since molding becomes difficult, it is preferable to keep a balance between them according to the purpose. Here, in this specification, a 6-membered ring, a condensed ring including a 6-membered ring and the like are basically regarded as a ring. For example, a 3-membered ring, a 4-membered ring, or a 5-membered ring alone is not regarded as a ring. In addition, a condensed ring such as a naphthalene ring and a fluorene ring is regarded as one ring.

Compound (1-1) may be optically active or optically inactive. When Compound (1-1) is optically active, Compound (1-1) may have an asymmetric carbon atom or may have axial asymmetry. The configuration of an asymmetric carbon atom may be R or S. The asymmetric carbon atom may be positioned in either R^{a} or A. When an asymmetric carbon atom is included, the compatibility of Compound (1-1) is favorable. When Compound (1-1) has axial asymmetry, a twisting induction force is large. In addition, light fixation is inconsequential in any case.

As described above, when types of the terminal group R^{a}, the ring structure A and the bond group Z, and the number of rings are appropriately selected, it is possible to obtain a compound having desired physical properties.

### • Compound (1-1)

Compound (1-1) can also be represented by the following Formula (1-a) or (1-b).

P-Y-(A-Z)ₘ-R^{a} (1-a)

P-Y-(A-Z)ₘ-Y-P (1-b)

In the above Formulae (1-a) and (1-b), A, Z, and R^{a} have the same definitions as A, Z, and R^{a} defined in the above Formula (1-1). P indicates polymerizable groups represented by the following Formulae (2-1) and (2-2), cyclohexene oxide, phthalic anhydride, or succinic anhydride, and Y is a single bond or an alkylene group having 1 to 20 carbon atoms, and preferably an alkylene group having 1 to 10 carbon atoms, and in the alkylene group, any -CH₂- is optionally substituted with -O-, -S-, -CO-, -COO-, -OCO- or -CH=CH-. A particularly preferable Y is an alkylene group in which -CH₂- at one end or both ends of an alkylene group having 1 to 10 carbon atoms is substituted with -O-. m is an integer of 1 to 6, preferably an integer of 2 to 6, and more preferably an integer of 2 to 4.

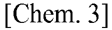

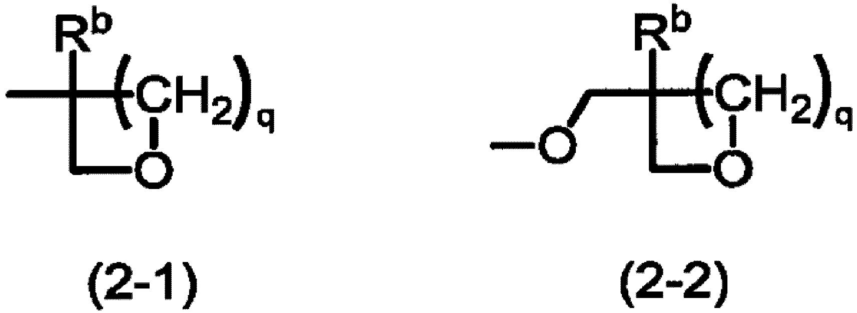

[in Formulae (2-1) and (2-2), R^{b} is a hydrogen atom, a halogen atom, -CF₃, or an alkyl group having 1 to 5 carbon atoms, and q is 0 or 1]

Preferable examples of Compound (1-1) include the following Compounds (a-1) to (a-10), (b-1) to (b-16), (c-1) to (c-16), (d-1) to (d-15), (e-1) to (e-15), (f-1) to (f-14), and (g-1) to (g-20). Here, in the formulae, * indicates an asymmetric carbon atom.

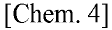

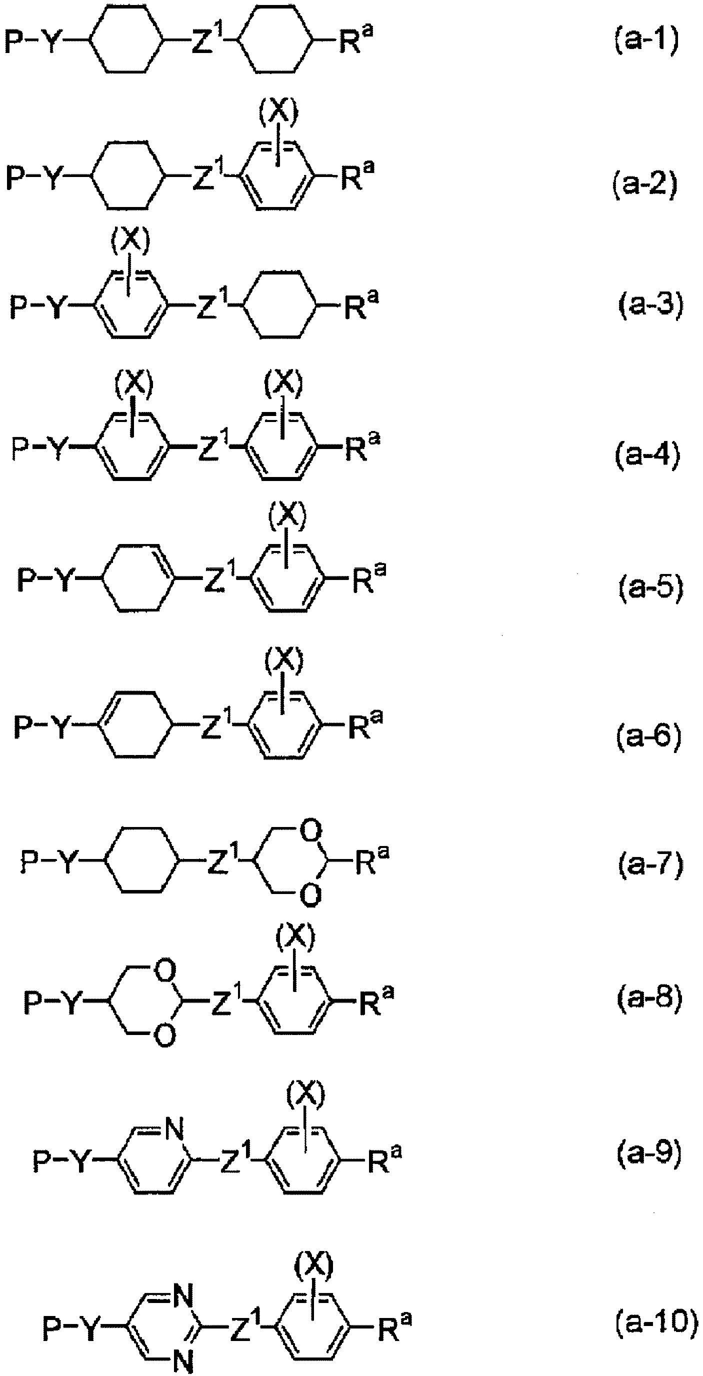

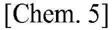

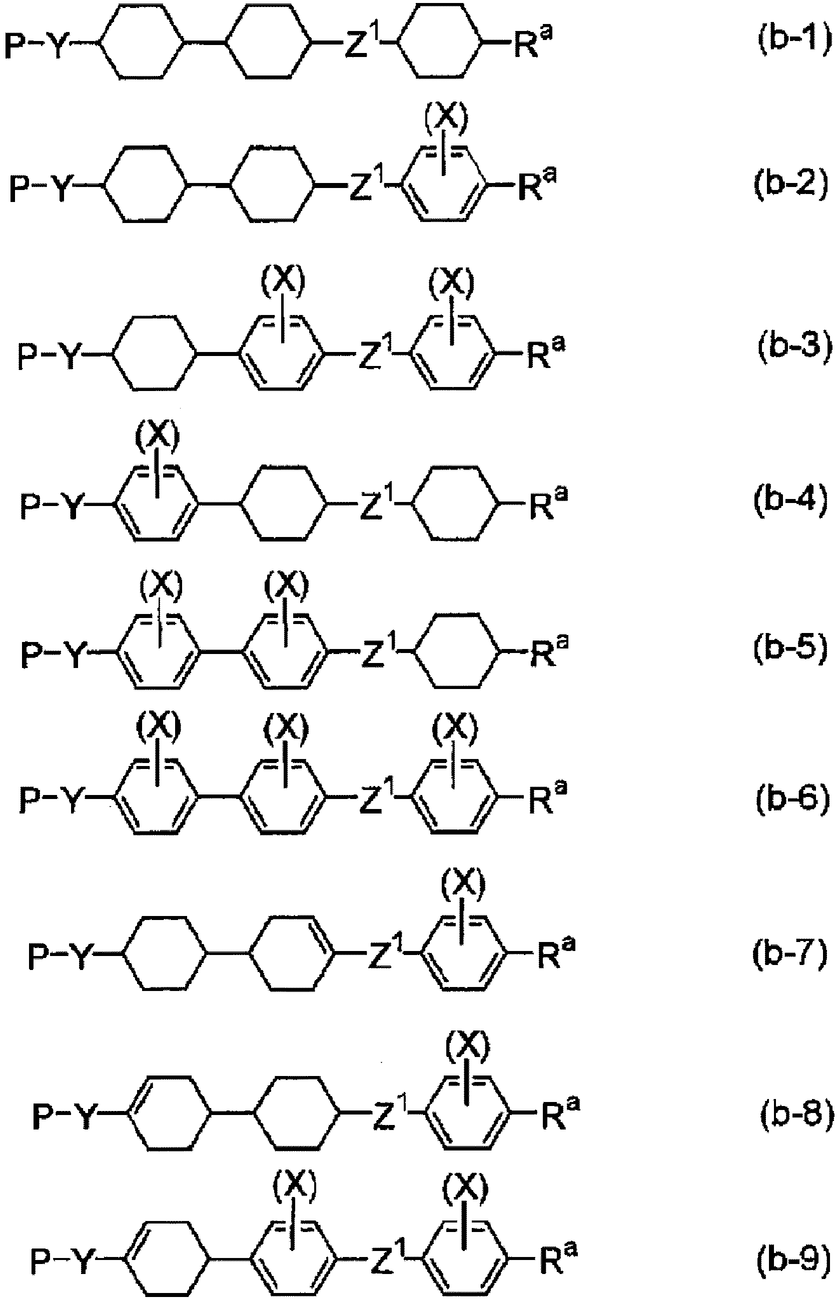

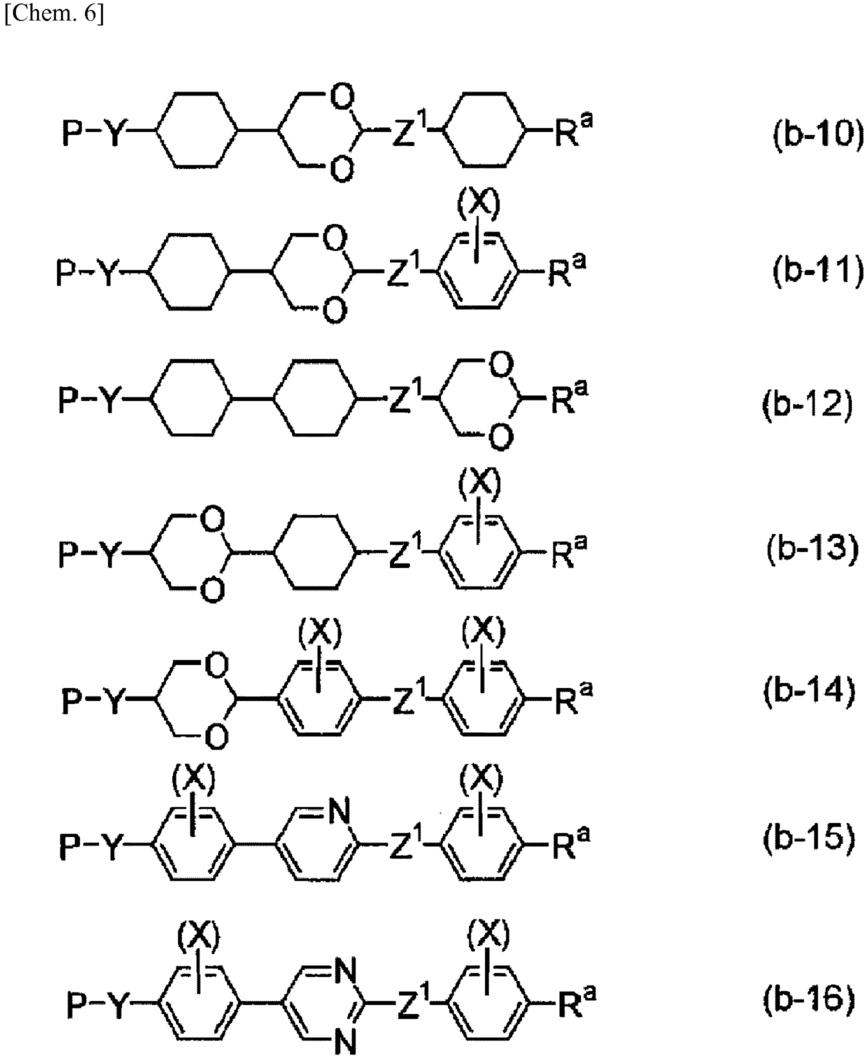

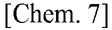

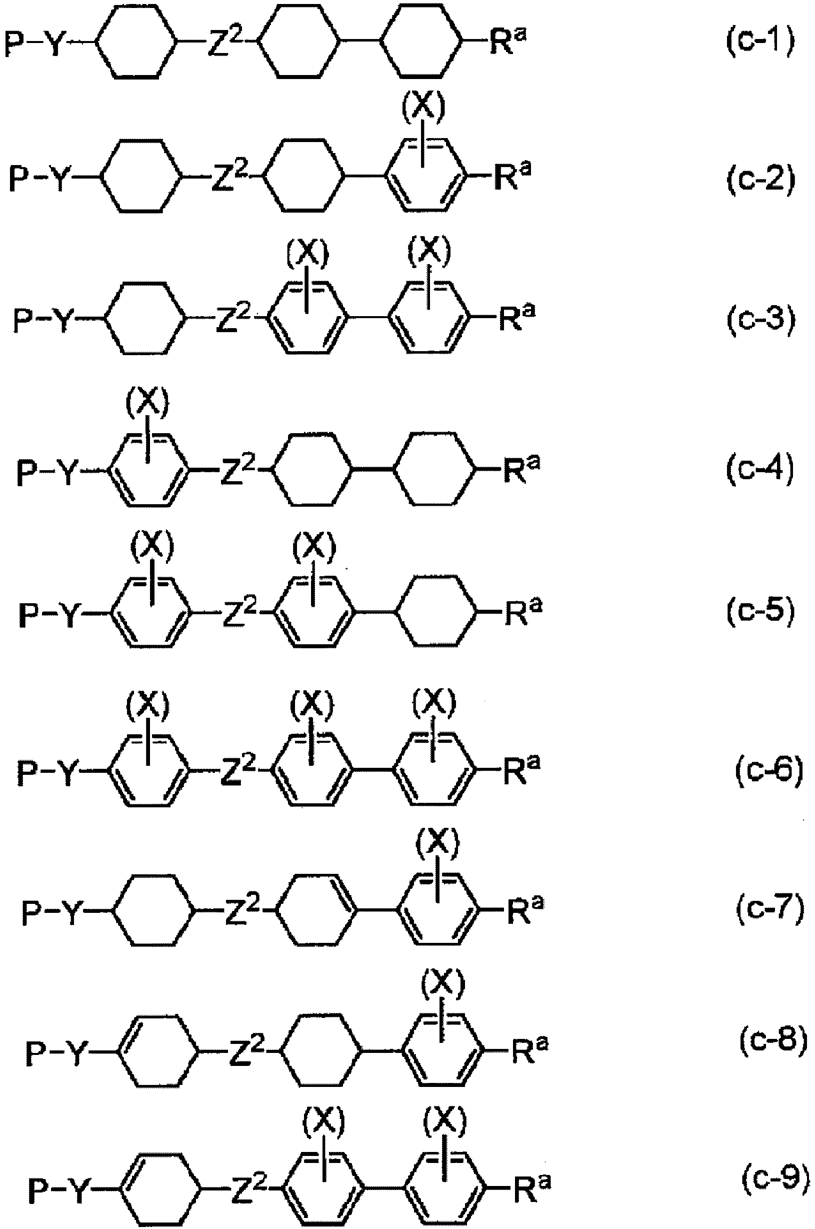

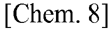

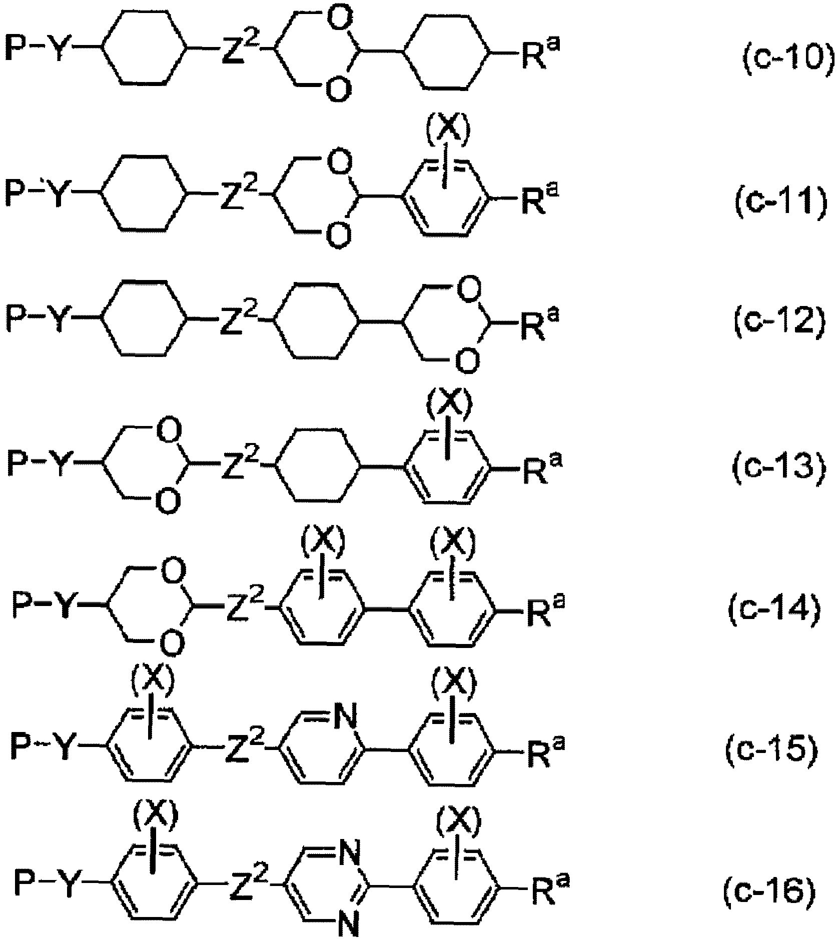

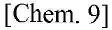

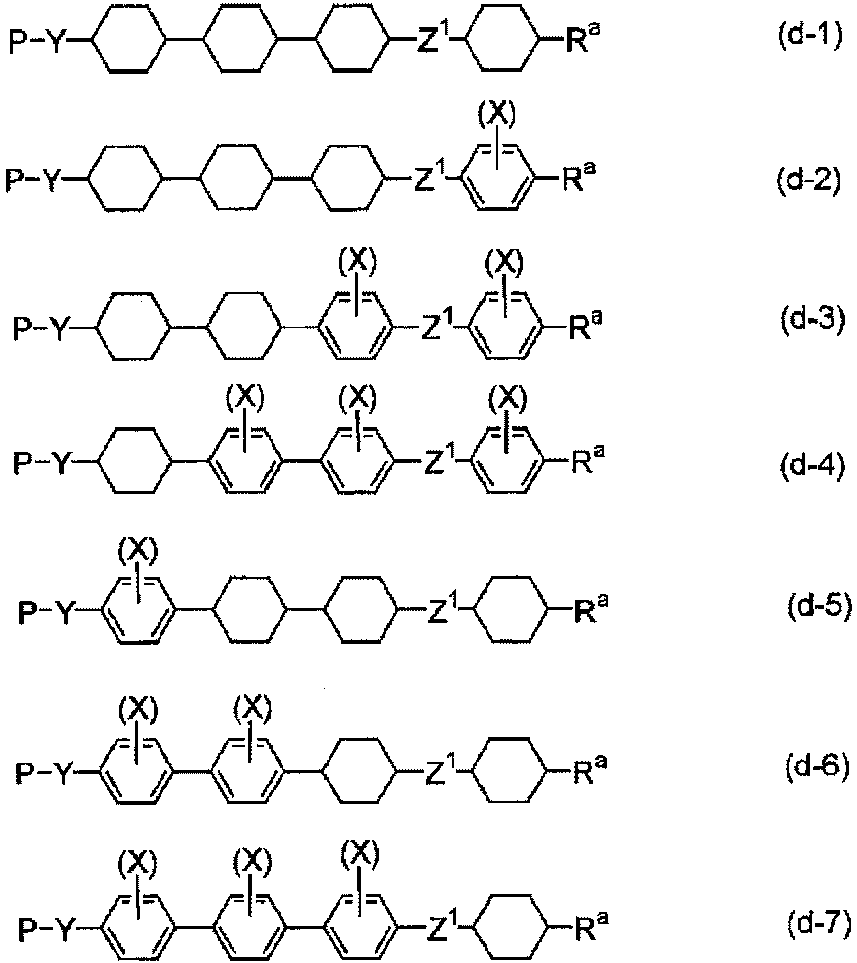

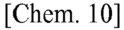

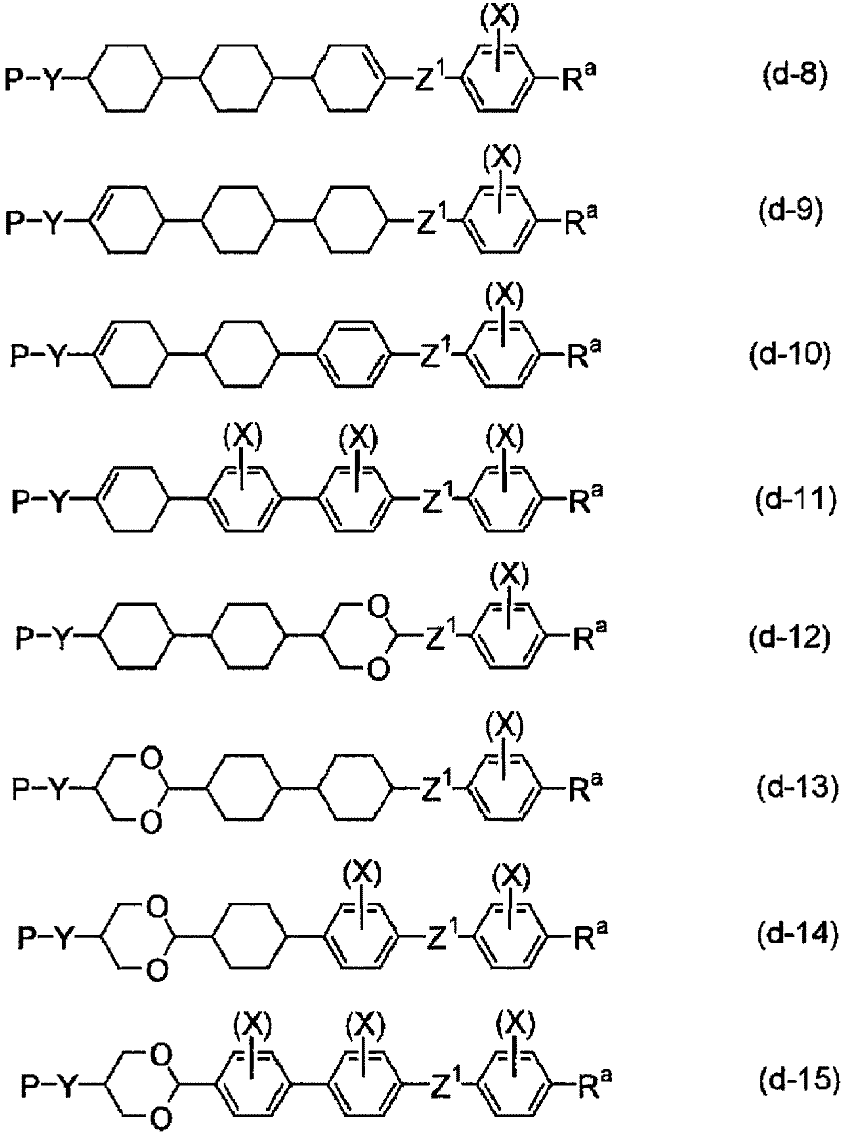

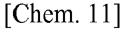

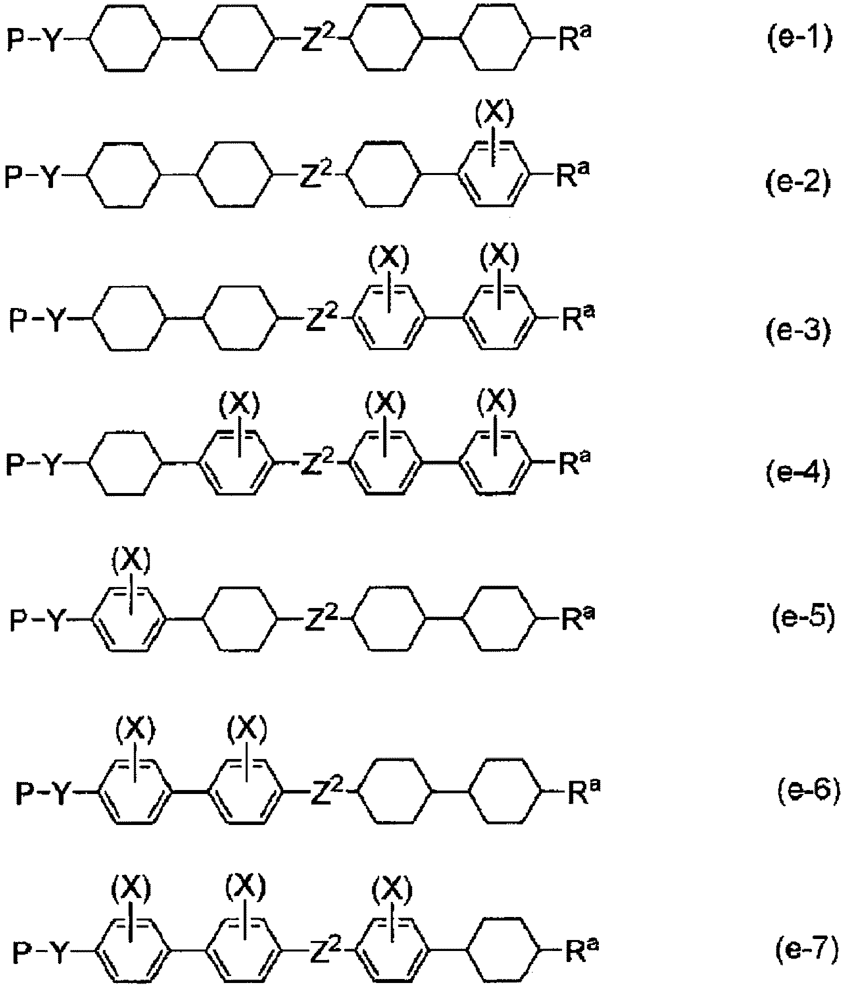

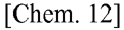

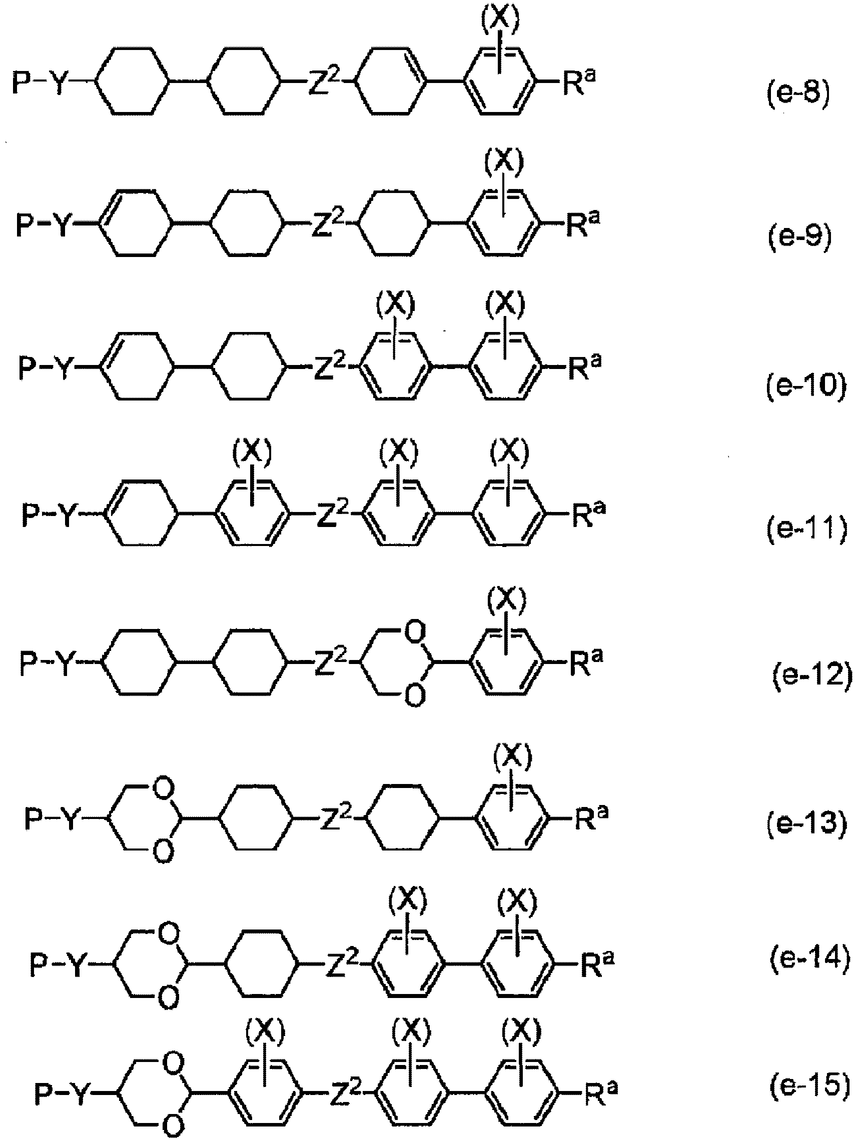

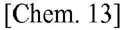

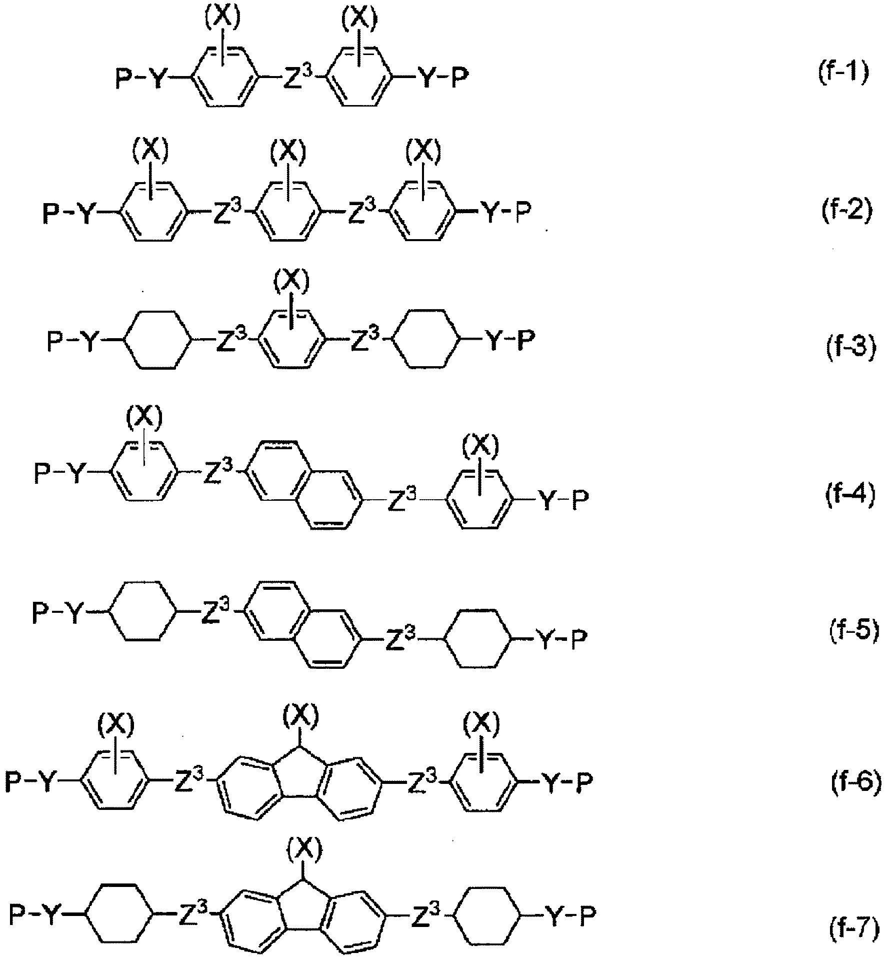

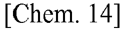

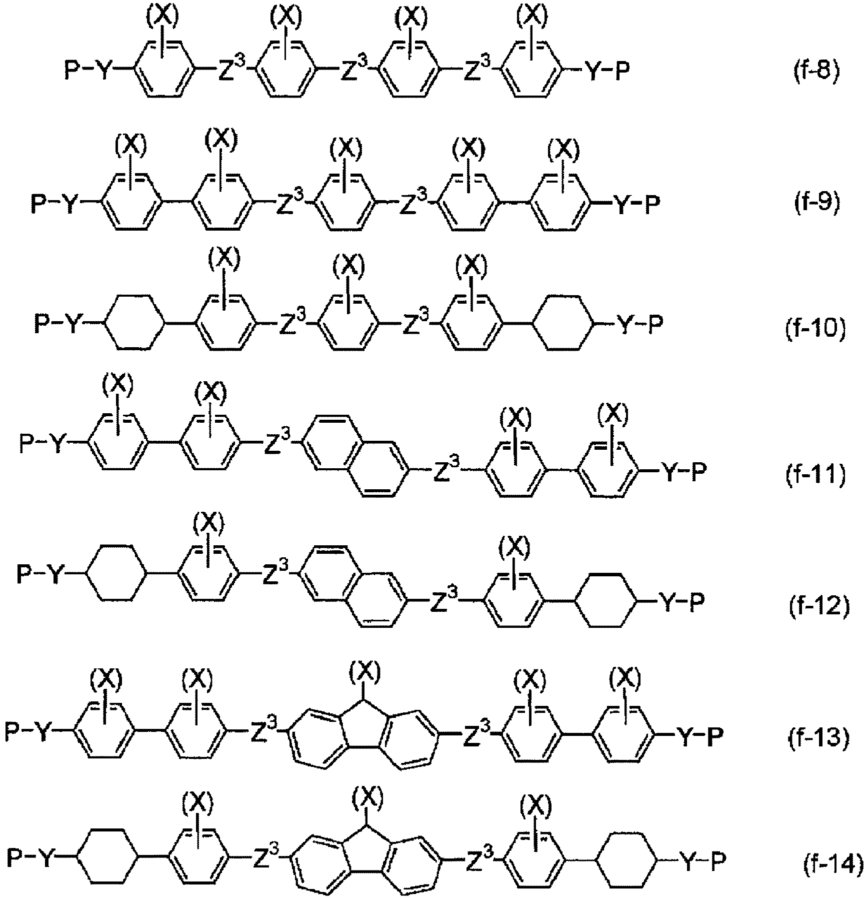

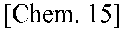

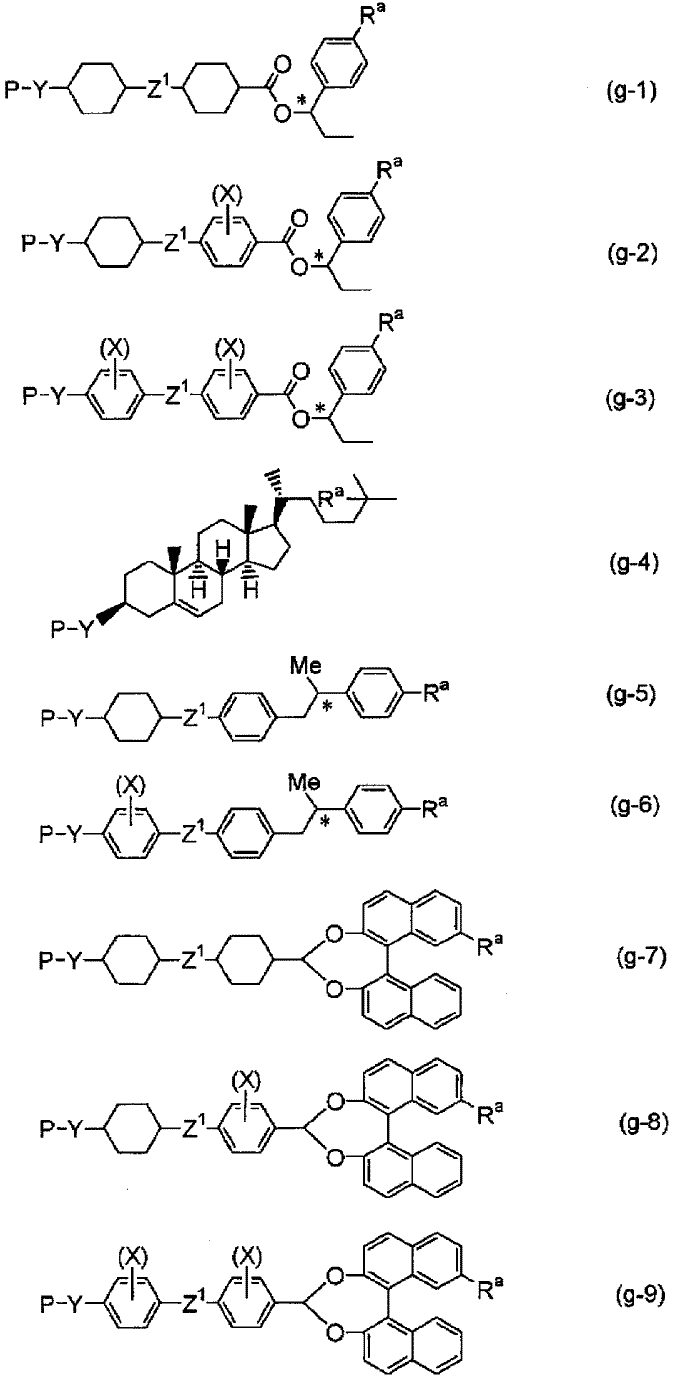

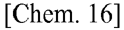

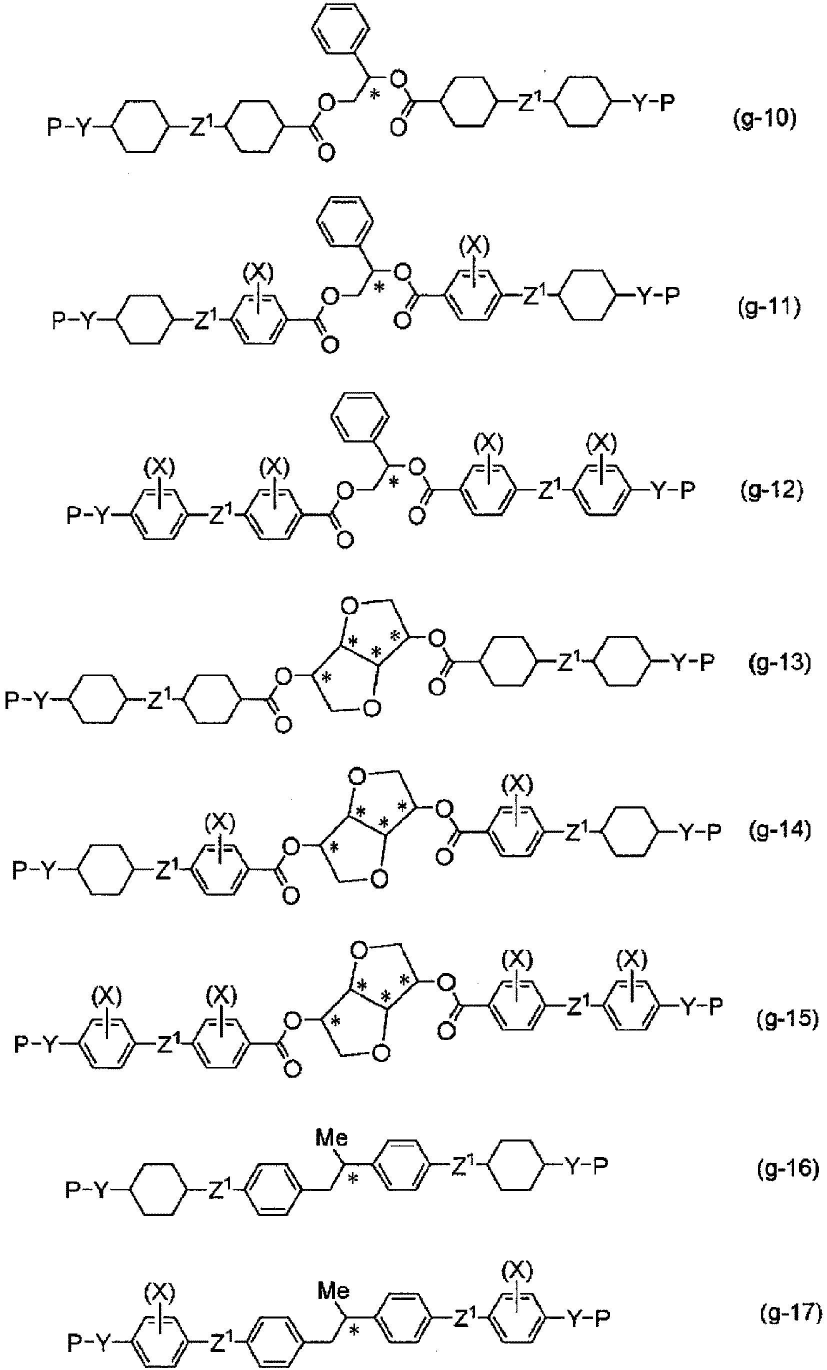

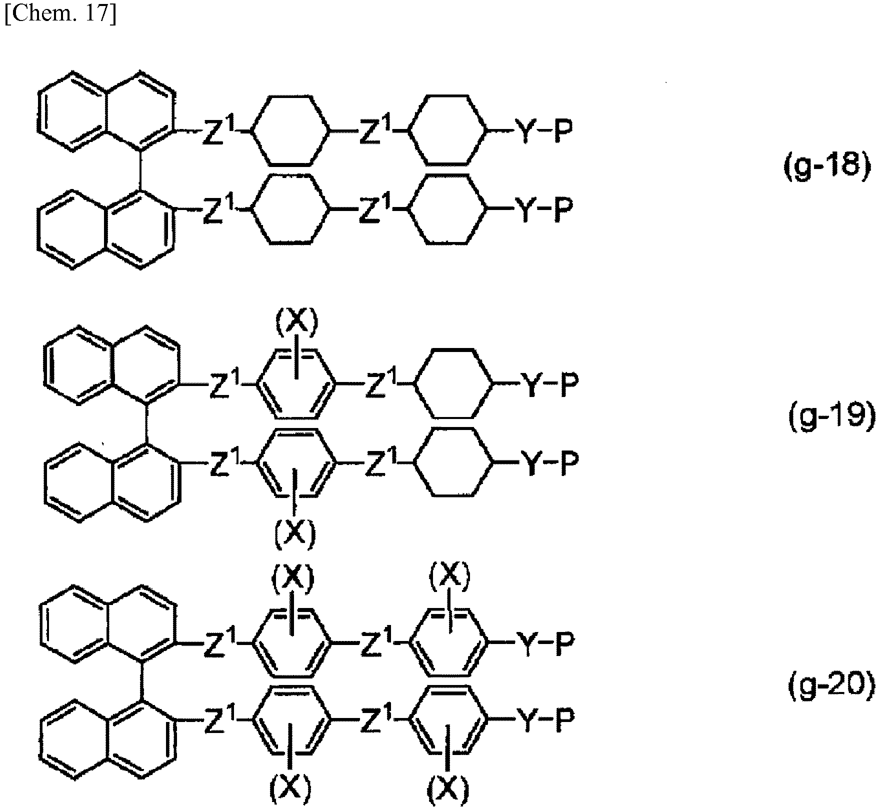

In the above Chemical Formulae (a-1) to (g-20), R^{a}, P and Y are as those defined in the above Formulae (1-a) and (1-b).

Z¹ independently represents a single bond, -(CH₂)₂-, -(CF₂)₂-, -(CH₂)₄-, -CH₂O-, -OCH₂-, -(CH₂)₃O-, -O(CH₂)₃-, -COO-, -OCO-, -CH=CH-, -CF=CF-, -CH=CHCOO-, -OCOCH=CH-, -(CH₂)₂COO-, -OCO(CH₂)₂-, -C=C-, -C=C-COO-, -OCO-C=C-, -C=C-CH=CH-, -CH=CH-C=C-, -CH=N-, -N=CH-, -N=N-, -OCF₂- or -CF₂O-. Here, a plurality of Z¹ may be the same as or different from each other.

Z² independently represents -(CH₂)₂-, -(CF₂)₂-, -(CH₂)₄-, -CH₂O-, -OCH₂-, -(CH₂)₃O-, -O(CH₂)₃-, -COO-, -OCO-, -CH=CH-, -CF=CF-, -CH=CHCOO-, -OCOCH=CH-, -(CH₂)₂COO-, -OCO(CH₂)₂-, -C=C-, -C=C-COO-, -OCO-C=C-, -C=C-CH=CH-, -CH=CH-C=C-, -CH=N-, -N=CH-, -N=N-, -OCF₂- or -CF₂O-.

Z³ independently represents a single bond, an alkyl group having 1 to 10 carbon atoms, -(CH₂)ₐ-, -O(CH₂)ₐO-, -CH₂O-, -OCH₂-, -O(CH₂)₃-, -(CH₂)₃O-, -COO-, -OCO-, -CH=CH-, -CH=CHCOO-, -OCOCH=CH-, -(CH₂)₂COO-, -OCO(CH₂)₂-, -CF=CF-, -C=C-, -CH=N-, -N=CH-, -N=N-, -OCF₂- or -CF₂O-, and a plurality of Z³ may be the same as or different from each other. a is an integer of 1 to 20.

X is a substituent of 1,4-phenylene and fluorene-2,7-diyl in which any hydrogen atom is optionally substituted with a halogen atom, an alkyl group, or an alkyl fluoride, and represents a halogen atom, an alkyl group or an alkyl fluoride.

More preferable forms of Compound (1-1) will be described. A more preferable Compound (1-1) can be represented by the following Formula (1-c) or (1-d).

P¹-Y-(A-Z)ₘ-R^{a} (1-c)

P¹-Y-(A-Z)ₘ-Y-P¹ (1-d)

In the formulae, A, Y, Z, R^{a} and m are as defined as above, and P¹ represents a polymerizable group represented by the following Formulae (2-1) and (2-2). In the above Formula (1-d), two P¹ represent the same polymerizable group (2-1) and (2-2), two Y represent the same group, and two Y are bonded to each other so that they are symmetric.

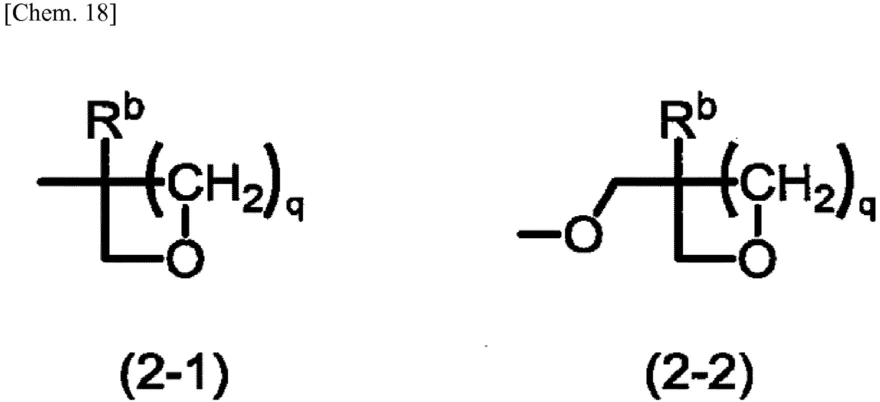

Specific examples of a more preferable Compound (1-1) are shown below.
[Chem. 19]

| | Y | -(A-Z)m- |
|---|---|---|
| (f-1-1) | single bond, | 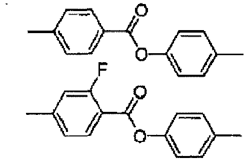 |
| | (CH₂)₂, (CH₂)₆, (CH₂)₄O, (CH₂)₅O | |
| (f-1-2) | single bond, | |
| | (CH₂)₃, (CH₂)₅, (CH₂)₃O, (CH₂)₆O | |
| (f-1-3) | single bond, | 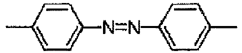 |
| | (CH₂)_{2.} (CH₂)₆, (CH₂)₄O, (CH₂)₆O | |
| (f-2-1) | single bond, | 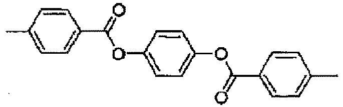 |
| | (CH₂)₃, (CH₂)₄, (CH₂)₃O, (CH₂)₆O | |
| (f-2-2) | single bond, | 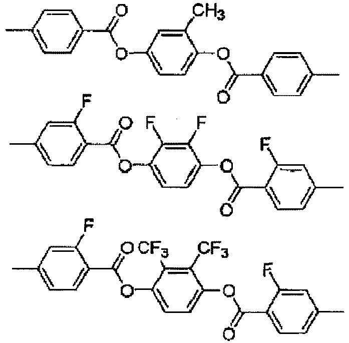 |
| | (CH₂)₄, (CH₂)₅, (CH₂)₄O, (CH₂)₆O | |
| (f-2-3) | single bond, | |
| | (CH₂)₂, (CH₂)₆, (CH₂)₃O, (CH₂)₆O | |
| (f-2-4) | (CH₂)₄, (CH₂)₅. (CH₂)₄O, (CH₂)₆O | |
| (f-2-5) | single bond, | 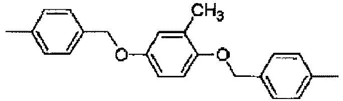 |
| | (CFF₂)₂, (CH₂)₆, (CH₂)₄O, (CH₂)₅O | |
| (f-2-6) | single bond, | |
| | (CH₂)₃, (CH₂)₆, (CH₂)₃O, (CH₂)₅O | 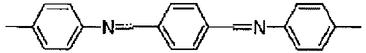 |
| (f-3-1) | single bond, | 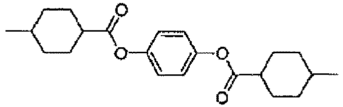 |
| | (CH₂)₃, (CH₂)₄, (CH₂)₃O, (CH₂)₆O | |
| (f-3-2) | single bond, | |
| | (CH₂)₅, (CH₂)₄O, (CH₂)₅O | 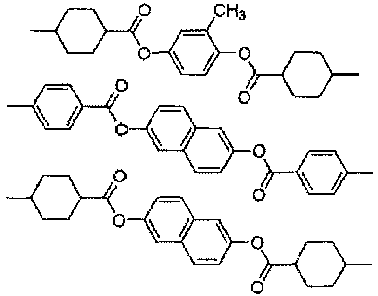 |
| (f-4-1) | single bond, | |
| | (CH₂)₂, (CH₂)₄, (CH₂)₆O, (CH₂)₇O | |
| (f-5-2) | single bond, | |
| | (CH₂)₃, (CH₂)₆, (CH₂)₄O, (CH₂)₆O | |

[Chem. 20]

| | Y | -(A-Z)m- |
|---|---|---|
| (f-6-1) | single bond, | 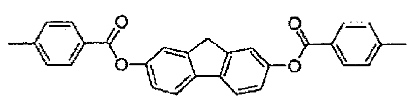 |
| | (CH₂)₃, (CH₂)₇, (CH₂)₃O, (CH₂)₆O | |
| (f-6-2) | single bond, | 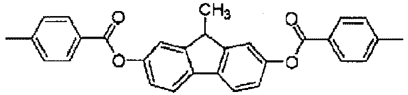 |
| | (CH₂)₃, (CH₂)₅, (CH₂)₄O, (CH₂)₆O | |
| (f-6-3) | single bond, | 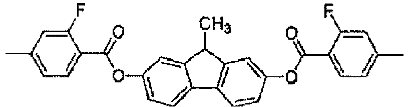 |
| | (CH₂)₄, (CH₂)₅, (CH₂)₃O, (CH₂)₆O | |
| (f-6-4) | single bond, | 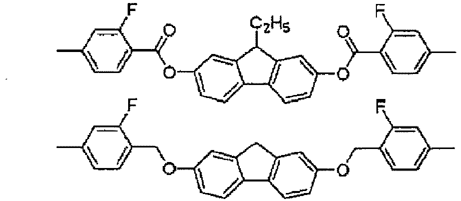 |
| | (CH₂)₃, (CH₂)₆, (CH₂)₄O, (CH₂)₅O | |
| (f-6-5) | single bond, | |
| | (CH₂)₄, (CH₂)₆, (CH₂)₃O, (CH₂)₄O | |
| (f-7-1) | single bond, | 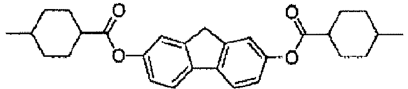 |
| | (CH₂)₄, (CH₂)₅, (CH₂)₂O, (CH₂)₆O | |
| (f-7-2) | single bond, | 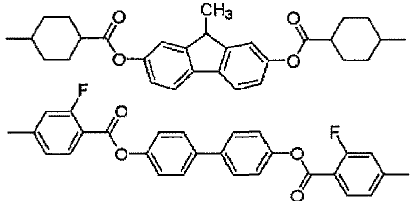 |
| | (CH₂)₃, (CH₂)₇, (CH₂)₃O, (CH₂)₅O | |
| (f-8-1) | single bond, | |
| | (CH₂)₃, (CH₂)₅, (CH₂)₃O, (CH₂)₆O | |
| (f-8-2) | single bond, | 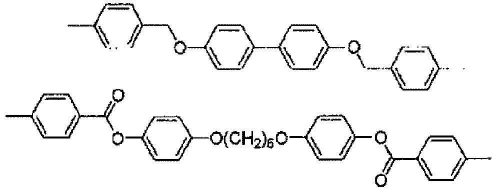 |
| | (CH₂)₅. (CH₂)₇. (CH₂)₂O, (CH₂)₅O | |
| (f-8-3) | single bond, | |
| | (CH₂)₃, (CH₂)₄, CH₃O, (CH₂)₄O | |
| (f-9-1) | single bond, | 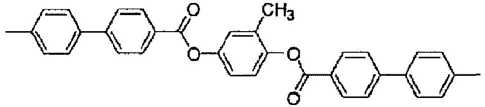 |
| | (CH₂)₂, (CH₂)₄, (CH₂)₄O, (CH₂)₅O | |
| (f-10-1) | single bond, | 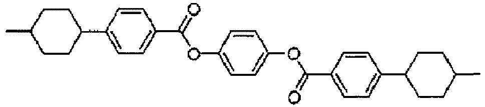 |
| | (CH₂)₃, (CH₂)₅, (CH₂)₃O, (CH₂)₆O | |

[Chem. 21]

| | Y | -(A-Z)m- |
|---|---|---|
| (f-11-1) | single bond, | 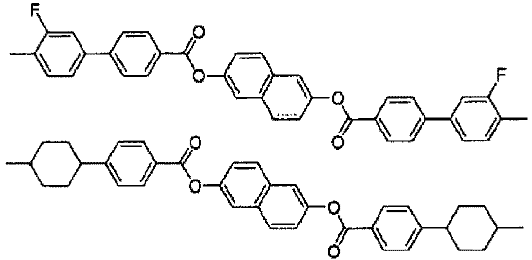 (CH₂)₆O (CH₂)₆O |
| | (CH₂)₄, (CH₂)₅, (CH₂)₃O, | |
| (f-12-1) | single bond, | |
| | (CH₂)₃, (CH₂)₅, (CH₂)₄O, | |
| (f-13-1) | single bond, | |
| | (CH₂)₃, (CH₂)₇, (CH₂)₃O, | 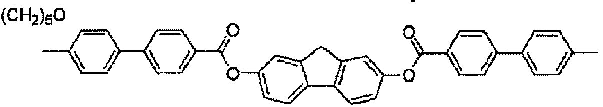 |
| (f-13-2) | single bond, | |
| | (CH₂)₄, (CH₂)₆, (CH₂)₃O, | 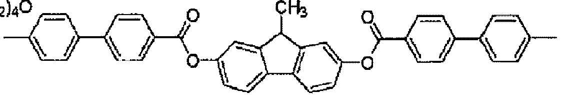 |
| (f-13-3) | single bond, | |
| | (CH₂)₃, (CH₂)₅, (CH₂)₄O, | 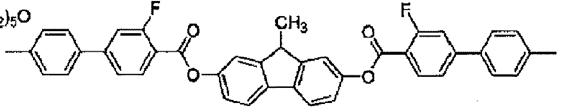 |
| (f-14-1) | single bond, | |
| | (CH₂)₃, (CH₂)₅, (CH₂)₃O, | 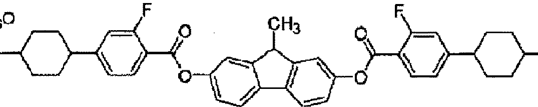 |
| (f-14-2) | single bond, | |
| | (CH₂)₃, (CH₂)₆, (CH₂)₃O, | 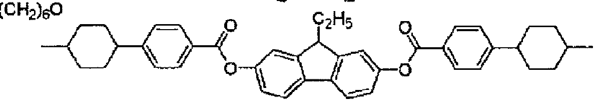 |

### • Method of synthesizing Compound (1-1)

Compound (1-1) can be synthesized by combining methods known in the field of organic synthetic chemistry. A method of introducing a desired terminal group, ring structure and bond group into a starting material is described in books such as, for example, Houben-Wyle (Methods of Organic Chemistry, Georg Thieme Verlag, Stuttgart), Organic Syntheses (John Wily & Sons, Inc.), Organic Reactions (John Wily & Sons Inc.), Comprehensive Organic Synthesis (Pergamon Press), and New Experimental Chemistry Course (Maruzen). In addition, Japanese Unexamined Patent Application Publication No. 2006-265527 may be referred to.

The bifunctional or higher polymerizable compound (hereinafter simply referred to as a "polymerizable compound" in some cases) may be a polymerizable compound that does not exhibit liquid crystallinity other than the polymerizable liquid crystal compound represented by the above Formula (1-1). For example, polyether diglycidyl ether, bisphenol A diglycidyl ether, bisphenol F diglycidyl ether, biphenol diglycidyl ether, and a compound that has insufficient linearity and exhibits no liquid crystallinity among compounds of Formula (1-1) may be exemplified.

The polymerizable compound can be synthesized by combining methods known in the field of organic synthetic chemistry.

The polymerizable compound used in the present invention preferably has a bifunctional or higher functional group for forming a bond with a coupling agent, a trifunctional or higher functional group, or a tetrafunctional or higher functional group. In addition, a compound having a functional group at both ends of the long side of the polymerizable compound is preferable because a linear bond can then be formed.

### <Inorganic fillers>

Examples of the first inorganic filler and the second inorganic filler include a nitride, a carbide, a carbon material, a metal oxide, and a silicate mineral. The first inorganic filler and the second inorganic filler may be the same as or different from each other.

Specifically, regarding the first inorganic filler and the second inorganic filler, examples of an inorganic filler having high thermal conductivity and a very small or negative thermal expansion coefficient include boron nitride, boron carbide, boron carbonitride, graphite, carbon fibers, and carbon nanotubes. In addition, alumina, silica, magnesium oxide, zinc oxide, iron oxide, ferrite, mullite, cordierite, silicon nitride, and silicon carbide can be exemplified.

In addition, the following inorganic filler having a high thermal conductivity and a positive thermal expansion coefficient may be used as either the first inorganic filler or the second inorganic filler.

Examples of a third inorganic filler include inorganic fillers and metal fillers such as alumina, silica, boron nitride, boron carbide, silicon carbide, aluminum nitride, silicon nitride, diamond, carbon nanotubes, graphite, graphene, silicon, beryllia, magnesium oxide, aluminum oxide, zinc oxide, silicon oxide, copper oxide, titanium oxide, cerium oxide, yttrium oxide, tin oxide, holmium oxide, bismuth oxide, cobalt oxide, calcium oxide, magnesium hydroxide, aluminum hydroxide, gold, silver, copper, platinum, iron, tin, lead, nickel, aluminum, magnesium, tungsten, molybdenum, and stainless steel, which have high thermal conductivity and a smaller size than the first and second inorganic fillers.

It is desirable that a structure of the polymerizable compound have a shape and a length at which these inorganic fillers can be efficiently directly bonded to each other. A type, a shape, a size, and an addition amount of an inorganic filler can be appropriately selected depending on the purpose. When insulation properties are necessary for the obtained thermal expansion-controlling member, an inorganic filler having conductivity may be used as long as desired insulation properties are maintained. Examples of the shape of the inorganic filler include a plate shape, a spherical shape, an amorphous shape, a fibrous shape, a rod shape, and a tubular shape.

Boron nitride, aluminum nitride, silicon nitride, silicon carbide, graphite, carbon fibers, and carbon nanotubes are preferable. In particular, hexagonal boron nitride (h-BN) and graphite are preferable. Boron nitride and graphite are preferable because they have very high thermal conductivity in the planar direction, and boron nitride has a low dielectric constant and has strong insulation properties. For example, plate-like crystal boron nitride is preferably used because the plate-like structure is likely to be aligned according to a mold due to a flow and a pressure of a raw material during molding and curing.

An average particle size of the inorganic filler is preferably 0.1 to 200 µm, and more preferably, 1 to 100 µm. When the average particle size is 0.1 µm or more, thermal conductivity is favorable, and when the average particle size is 200 µm or less, a filling rate can increase.

Here, in this specification, the average particle size is based on particle size distribution measurement using a laser diffraction and scattering method. That is, using analysis according to the Fraunhofer diffraction theory and the Mie scattering theory, powder is divided into two sides with respect to a certain particle size using a wet method, and a size at which the larger side and the smaller side are equal (based on the volume) is set as a median size.

Proportions of the inorganic filler, the coupling agent, and the polymerizable compound depend on an amount of the coupling agent bonded to the inorganic filler used. A compound (for example, boron nitride) used as the first and second inorganic fillers does not have a reactive group on its surface as described above and has a reactive group only on its side. Preferably, as much coupling agent as possible is bonded to few reactive groups, and the same number of or slightly more organic compound molecules as or than the number of reactive groups are bonded thereto. An amount of the coupling agent reacted with the inorganic filler varies mainly depending on the size of the inorganic filler and the reactivity of the coupling agent used. For example, when the inorganic filler is larger, since a proportion of an area of the side of the inorganic filler is smaller, an amount of modification is smaller. Although it is desirable to react as much coupling agent as possible, when particles become smaller, since thermal conductivity of the product is lowered, it is preferable to keep a balance.

A volume ratio between the silane coupling agent and the polymerizable compound in the thermal expansion-controlling member which is a cured product and the inorganic component is desirably in a range of 5:95 to 30:70, and more desirably in a range of 10:90 to 25:75. The inorganic component is an inorganic raw material before a silane coupling agent treatment or the like is performed.

### <Coupling agent>

In a coupling agent bonded to the inorganic filler, when a functional group of a bifunctional or higher polymerizable compound is oxiranyl, an acid anhydride residue, or the like, since it is preferable that the coupling agent react with these functional groups, it is preferable that the coupling agent have an amine reactive group at the terminus. Sila-Ace (registered trademark) S310, S320, S330, and S360 (commercially available from JNC) and KBM903 and KBE903 (commercially available from Shin-Etsu Chemical Co., Ltd.) may be exemplified.

Here, when the terminus of the bifunctional or higher polymerizable compound is an amine, a coupling agent having an oxiranyl group or the like at the terminus is preferable. Examples of the coupling agent include Sila-Ace (registered trademark) S510 and S530 (commercially available from JNC). Here, modification of inorganic fillers using a coupling agent is preferable because the number of bonds increases as the number of modifications increases.

The first coupling agent and the second coupling agent may be the same as or different from each other.

As the first inorganic filler, an inorganic filler that is treated with a coupling agent and then additionally subjected to surface modification with a bifunctional or higher polymerizable compound is used. For example, in an inorganic filler (inorganic filler bonded to a coupling agent) treated with a silane coupling agent, a bifunctional or higher polymerizable compound may be additionally bonded to the coupling agent, and thus the inorganic filler is subjected to surface modification with a polymerizable compound. As shown in FIG. 2, the first inorganic filler subjected to surface modification with a polymerizable compound can form a bond with the second inorganic filler using the polymerizable compound and coupling, and the bond greatly contributes to thermal conduction.

Here, as the first inorganic filler, an inorganic filler that is subjected to a coupling treatment using a coupling agent bonded to a bifunctional or higher polymerizable compound in advance may be used.

As the bifunctional or higher polymerizable compound, the bifunctional or higher polymerizable liquid crystal compound represented by the above Formula (1-1) is preferable. However, other polymerizable liquid crystal compounds may be used, and a polymerizable compound having no liquid crystallinity may be used. When the polymerizable compound is polycyclic, this is desirable because heat resistance is high, and when the linearity is high, elongation and fluctuation between inorganic fillers due to heat are small, and moreover, it is possible to efficiently transfer phonons in heat conduction. When the polymerizable compound is polycyclic and has high linearity, liquid crystallinity is exhibited as a result in many cases. Therefore, it can be said that thermal conduction is improved if the polymerizable compound has liquid crystallinity.

Here, when an amount of surface modification using a polymerizable compound or the like is excessively small, since the number of molecules that bond fillers is excessively small, the strength decreases. On the other hand, when an amount of surface modification using a polymerizable compound or the like is excessively large, properties of a resin such as exhibition of a glass transition temperature are strongly exhibited. Therefore, depending on required properties, it is desirable to appropriately adjust an amount of surface modification.

### <Other components>

The composition for a thermal expansion-controlling member may further contain an organic compound (for example, a polymerizable compound or a polymer compound) that is not bonded to the first inorganic filler or the second inorganic filler, that is, does not contribute to bonding, and may contain a polymerization initiator, a solvent, and the like.

### <Polymerizable compound that is not bonded>

The composition for a thermal expansion-controlling member may contain a polymerizable compound (in this case, it need not be a bifunctional or higher polymerizable compound) that is not bonded to an inorganic filler as a component. As such a polymerizable compound, a compound that does not prevent thermal curing of the inorganic filler and does not evaporate or bleed out due to heat is preferable. Such polymerizable compounds are classified into compounds having no liquid crystallinity and compounds having liquid crystallinity. Examples of the polymerizable compound having no liquid crystallinity include vinyl derivatives, styrene derivatives, (meth)acrylic acid derivatives, sorbic acid derivatives, fumaric acid derivatives, and itaconic acid derivatives. Regarding a content, first, desirably, a composition for a thermal expansion-controlling member that does not contain a polymerizable compound that is not bonded is produced, a porosity thereof is measured, and the polymerizable compound is added in an amount at which voids are filled.

### <Polymer compound that is not bonded>

The composition for a thermal expansion-controlling member may contain a polymer compound that is not bonded to an inorganic filler as a component. As such a polymer compound, a compound that does not degrade film forming properties and mechanical strength is preferable. The polymer compound may be a polymer compound that does not react with the inorganic filler, the coupling agent, and the polymerizable compound. For example, when the polymerizable compound is an oxiranyl and the silane coupling agent has an amino group, a polyolefin resin, a polyvinyl resin, a silicone resin, a wax, and the like may be exemplified. Regarding a content, first, desirably, a composition for a thermal expansion-controlling member that does not contain a polymer compound that is not bonded is produced, a porosity thereof is measured, and the polymer compound is added in an amount at which voids are filled.

### <Non-polymerizable liquid crystalline compound>

The composition for a thermal expansion-controlling member may contain a liquid crystalline compound having no polymerizable group as a component. Examples of such a non-polymerizable liquid crystalline compound are described in the liquid crystalline compound database LiqCryst (LCI Publisher GmbH, Hamburg, Germany), and the like. When the composition containing a non-polymerizable liquid crystalline compound is polymerized, for example, it is possible to obtain composite materials of the polymer of Compound (1-1) and the liquid crystalline compound. In such composite materials, a non-polymerizable liquid crystalline compound is present in a polymer network such as a polymer dispersed liquid crystal. Therefore, a liquid crystalline compound having properties such that it has no fluidity in a temperature range in which it is used is desirable. Combining may be performed in such a manner in which, after the inorganic filler is cured, it is injected into voids in a temperature range in which an isotropic phase is exhibited or inorganic fillers may be polymerized by mixing in an amount of the liquid crystalline compound computed in advance such that voids are filled in the inorganic fillers.

### <Polymerization initiator>

The composition for a thermal expansion-controlling member may contain a polymerization initiator as a component. As the polymerization initiator, according to components and a polymerization method of the composition, for example, a photo radical polymerization initiator, a photocationic polymerization initiator, and a thermal radical polymerization initiator may be used. In particular, since the inorganic filler absorbs ultraviolet rays, a thermal radical polymerization initiator is preferable.

Examples of a preferable initiator for thermal radical polymerization include benzoyl peroxide, diisopropyl peroxydicarbonate, t-butylperoxy-2-ethylhexanoate, t-butyl peroxypivalate, di-t-butyl peroxide (DTBPO), t-butyl peroxydiisobutyrate, lauroyl peroxide, dimethyl 2,2'-azobisisobutyrate (MAIB), azobisisobutyronitrile (AIBN), and azobiscyclohexanecarbonitrile (ACN).

### <Solvent>

The composition for a thermal expansion-controlling member may contain a solvent. When a component that needs to be polymerized is contained in the composition, polymerization may be performed in a solvent or without a solvent. The composition containing a solvent may be applied onto a substrate, using, for example, a spin coating method, and then photopolymerized after the solvent is removed. Alternatively, after photocuring, heating may be performed to an appropriate temperature, curing may be performed by heating and thus a post treatment may be performed.

Examples of a preferable solvent include benzene, toluene, xylene, mesitylene, hexane, heptane, octane, nonane, decane, tetrahydrofuran, γ-butyrolactone, N-methyl pyrrolidone, dimethylformamide, dimethylsulfoxide, cyclohexane, methylcyclohexane, cyclopentanone, cyclohexanone, and PGMEA. The above solvents may be used alone, or two or more types thereof may be used in combination.

Here, there is little point in limiting a proportion of a solvent used during polymerization. In consideration of polymerization efficiency, solvent cost, energy cost, and the like, the proportion may be determined for each case.

### <Others>

In order to facilitate handling, a stabilizer may be added to the composition for a thermal expansion-controlling member. As such a stabilizer, a known stabilizer can be used without limitation. Examples of the stabilizer include hydroquinone, 4-ethoxyphenol, and 3,5-di-t-butyl-4-hydroxytoluene (BHT).

In addition, an additive (such as an oxide) may be added in order to adjust the viscosity or color of the composition for a thermal expansion-controlling member. For example, titanium oxide for exhibiting white, carbon black for exhibiting black, and a fine silica powder for adjusting the viscosity can be exemplified. In addition, an additive may be added in order to further increase mechanical strength. For example, as inorganic fibers such as glass fibers, carbon fibers, and carbon nanotubes, cloth, or a polymer additive, fibers or long molecules of polyvinyl formal, polyvinyl butyral, polyester, polyamide, and polyimide may be exemplified.

### «Production method»

A method of producing a composition for a thermal expansion-controlling member and a method of producing a thermal expansion-controlling member from the composition will be described below in detail.

### (1) Performing a coupling treatment

A coupling treatment is performed on an inorganic filler, and a form in which one end of a coupling agent is bonded to an inorganic filler is referred to as a second inorganic filler. The coupling treatment can be performed using a known method.

As an example, first, the inorganic filler and the coupling agent are added to a solvent. After stirring is performed using a stirrer or the like, drying is performed. After the solvent is dried, a heat treatment is performed under vacuum conditions using a vacuum dryer or the like. A solvent is added to the inorganic filler and pulverization is performed using an ultrasonic treatment. This solution is separated and purified using a centrifuge. After the supernatant is discarded, the solvent is added, and the same operation is performed several times. The inorganic filler subjected to a coupling treatment after purification is dried using an oven.

### (2) Modification with polymerizable compound

A bifunctional or higher polymerizable compound is bonded to the other end of the coupling agent of the inorganic filler (that may be the same as or different from the above second inorganic filler) subjected to a coupling treatment. The inorganic filler modified with the polymerizable compound in this manner is referred to as a first inorganic filler.

As an example, the inorganic filler subjected to a coupling treatment and a bifunctional or higher polymerizable compound are mixed using an agate mortar or the like, and kneading is then performed using two rollers. Then, separation and purification are performed through an ultrasonic treatment and centrifugation.

### (3) Mixing

The first inorganic filler and the second inorganic filler are weighed out such that, for example, weights of only the inorganic fillers are 1:1, and mixing is performed using an agate mortar or the like. Then, mixing is performed using two rollers or the like, and a composition for a thermal expansion-controlling member is obtained.

Regarding a mixing ratio between the first inorganic filler and the second inorganic filler, when bond groups that form a bond between the first inorganic filler and the second inorganic filler are amine:epoxy groups, for example, weights of only the inorganic fillers are preferably 1:1 to 1:30 (weight ratio), and more preferably 1:3 to 1:20. The mixing ratio is determined according to the number of terminal bond groups that form a bond between the first inorganic filler and the second inorganic filler. For example, in the case of a secondary amine, since it can react with two oxiranyl groups, it may be used in a smaller amount compared to the oxiranyl side, and since the oxiranyl side may be ring-opened, a greater amount than that computed from the epoxy equivalent is preferably used.

### (4) Producing a thermal expansion-controlling member

As an example, a method of producing a film as a thermal expansion-controlling member using a composition for a thermal expansion-controlling member will be described. A composition for a thermal expansion-controlling member is inserted between heating plates using a compression molding machine and aligned, cured and molded by compression molding. In addition, post-curing is performed using an oven or the like, and a thermal expansion-controlling member is obtained. Here, a pressure during compression molding is preferably 50 to 200 kgf/cm² and more preferably 70 to 180 kgf/cm². Basically, a higher pressure during curing is preferable. However, a pressure is appropriately changed according to the fluidity of the mold and desired physical properties (in which direction to emphasize the thermal conductivity in), and an appropriate pressure is preferably applied.

Hereinafter, a method of producing a film as a thermal expansion-controlling member using a composition for a thermal expansion-controlling member containing a solvent will be described in detail.

First, the composition is applied to the substrate, the solvent is dried and removed, and a coating layer with a uniform film thickness is formed. Examples of the coating method include spin coating, roll coating, curtain coating, flow coating, printing, micro gravure coating, gravure coating, wire bar coating, dip coating, spray coating, and a meniscus coating method.

The solvent can be dried and removed by, for example, air-drying at room temperature, drying on a hot plate, drying in a drying furnace, blowing warm air or hot air, or the like. Conditions for removing the solvent are not particularly limited, and it is sufficient to perform drying until the solvent is substantially removed and the fluidity of a coating layer disappears.

Examples of the substrate include metal substrates of copper, aluminum, iron and the like; inorganic semiconductor substrates of silicon, silicon nitride, gallium nitride, and zinc oxide; glass substrates of alkali glass, borosilicate glass, and flint glass, and inorganic insulating substrates of alumina and aluminum nitride; and plastic film substrates of polyimide, polyamideimide, polyamide, polyetherimide, polyether ether ketone, polyether ketone, polyketone sulfide, polyethersulfone, polysulfone, polyphenylene sulfide, polyphenylene oxide, polyethylene terephthalate, polybutylene terephthalate, polyethylene naphthalate, polyacetal, polycarbonate, polyarylate, an acrylic resin, polyvinyl alcohol, polypropylene, cellulose, triacetyl cellulose, and partially saponified products thereof, and an epoxy resin, a phenol resin, a norbornene resin, and the like.

The film substrate may be a uniaxially stretched film or a biaxially stretched film. The film substrate may be subjected to a surface treatment such as a saponification treatment, a corona treatment, or a plasma treatment in advance. Here, on such film substrates, a protective layer that is not affected by the solvent contained in the composition for a thermal expansion-controlling member may be formed. Examples of a material used for the protective layer include a polyvinyl alcohol. In addition, an anchor coat layer may be formed in order to improve the adhesion between the protective layer and the substrate. For such an anchor coat layer, any of inorganic and organic materials may be used as long as it can improve the adhesion between the protective layer and the substrate.

A case in which a bond between the inorganic fillers is composed of an inorganic filler subjected to a coupling treatment and an inorganic filler that is subjected to a coupling treatment and further modified with a polymerizable compound has been described above. Specifically, for example, the second inorganic filler is subjected to a coupling treatment using a silane coupling agent having an amino group. After the first inorganic filler is subjected to a coupling treatment using a silane coupling agent having an amino group, the amino group and one end of the bifunctional or higher polymerizable compound having an epoxy group at both ends are bonded to each other. Finally, the amino group on the side of the second inorganic filler and the other epoxy group of the polymerizable compound on the side of the second inorganic filler are bonded to each other (refer to FIG. 2). Here, a combination in which the inorganic filler side has an epoxy group and the polymerizable compound side has an epoxy group may be used.

As another method, a coupling agent modified with a bifunctional or higher polymerizable compound in advance can be used. For example, the second inorganic filler is subjected to a coupling treatment using a silane coupling agent having an amino group. Next, a silane coupling agent having a vinyl group is modified with a polymerizable compound having a vinyl group and an epoxy group at the terminus, and the first inorganic filler is then subjected to a coupling treatment using the modified silane coupling agent. Finally, the amino group on the side of the second inorganic filler and the epoxy group of the polymerizable compound on the side of the first inorganic filler are bonded to each other.

In addition, as another method, the first and second inorganic fillers treated with a coupling agent and the bifunctional or higher polymerizable liquid crystal compound (such as a liquid crystal epoxy compound) computed from an amount of modification of the coupling agent may be mixed and pressed. When heating is performed while performing pressing, first, the polymerizable liquid crystal compound is brought into a liquid crystal state and enters gaps of the inorganic fillers. When additional heating is performed, a bond between the first inorganic filler and the second inorganic filler can be formed (that is, cured).

For example, as shown in FIG. 3, the composition for a thermal expansion-controlling member may be a composition including a first inorganic filler 1 bonded to one end of a first coupling agent 11 and a second inorganic filler 2 bonded to one end of a second coupling agent 12. The other end of the first coupling agent 11 and the other end of the second coupling agent 12 are not bonded to each other.

As shown in FIG. 3, when the composition for a thermal expansion-controlling member is cured, the other end of the first coupling agent 11 is bonded to the other end of the second coupling agent 12.

In this manner, a bond between the inorganic fillers may be formed according to a bond between coupling agents without using a polymerizable compound. For example, the first inorganic filler is subjected to a coupling treatment using a silane coupling agent having an amino group. The second inorganic filler is subjected to a coupling treatment using a silane coupling agent having an epoxy group. Finally, the amino group on the side of the first inorganic filler and the epoxy group on the side of the second inorganic filler are bonded to each other. In this manner, the coupling agent bonded to the first inorganic filler and the coupling agent bonded to the second inorganic filler each have a functional group for bonding coupling agents. The functional group on the side of the first inorganic filler and the functional group on the side of the second inorganic filler may be a combination of different types of functional groups or a combination of the same type of functional group as long as it is possible to bond coupling agents to each other.

Examples of a combination of functional groups that form a bond between coupling agents include a combination of an oxiranyl group and an amino group, a combination of vinyl groups, a combination of methacryloxy groups, a combination of a carboxy or carboxylic acid anhydride residue and an amino group, and a combination of imidazole and an oxiranyl group, but the present invention is not limited thereto. A combination with high heat resistance is more preferable.

In a form in which a bond between the inorganic fillers is formed according to a bond between coupling agents, a liquid crystal silane coupling agent may be used for at least one of the coupling agents. The "liquid crystal silane coupling agent" refers to a silane coupling agent represented by the following Formula (1) having a mesogenic site in a framework of a silane coupling agent. The mesogenic site has liquid crystallinity. In addition, the liquid crystal silane coupling agent contains a silicon compound including a polymerizable compound and an alkoxy group in its structure.

(R₁-O-)ⱼR₅₍₃₋ⱼ₎Si-R^{c}-Z⁴-(A¹-Z⁴)ₘ-R^{a1} (1)

When Compound (1) is mixed with other liquid crystalline compounds, polymerizable compounds, or the like, the mixture is likely to be uniform.

### • Terminal group R^{a1}

The terminal group R^{a1} is preferably a polymerizable group not containing a -C=C- or -C≡C- moiety. For example, polymerizable groups represented by the following Formulae (2-1) and (2-2), cyclohexene oxide, phthalic anhydride, and succinic anhydride can be exemplified, but the present invention is not limited thereto.

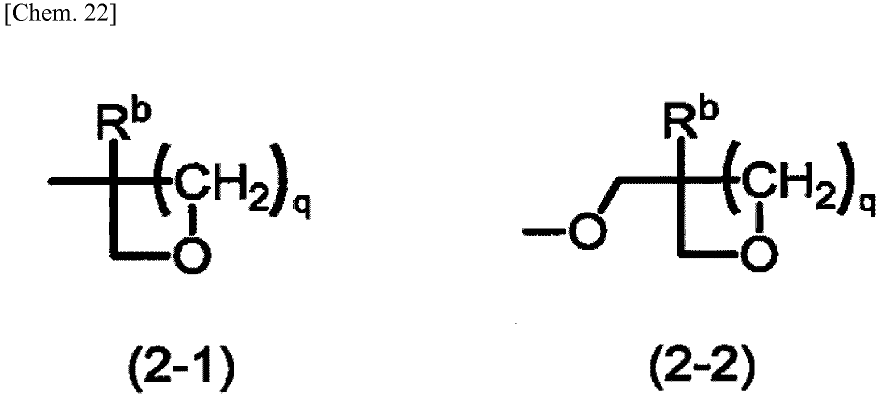

[in Formulae (2-1) and (2-2), R^{b} is a hydrogen atom, a halogen atom, -CF₃, or an alkyl group having 1 to 5 carbon atoms, and q is 0 or 1]

The terminal group R^{a1} may be a group including a functional group that can be bonded to a functional group of an organic compound which is a binding partner. Examples of a combination of functional groups that can be bonded to each other include a combination of an oxiranyl group and an amino group, a combination of methacryloxy groups, a combination of a carboxy or carboxylic acid anhydride residue and an amino group, and a combination of imidazole and an oxiranyl group, but the present invention is not limited thereto. A combination with high heat resistance is more preferable.

### •Ring structure A¹

Examples of a preferable A¹ include 1,4-cyclohexylene, 1,4-cyclohexenylene, 2,2-difluoro-1,4-cyclohexylene, 1,3-dioxane-2,5-diyl, 1,4-phenylene, 2-fluoro-1,4-phenylene, 2,3-difluoro-1,4-phenylene, 2,5-difluoro-1,4-phenylene, 2,6-difluoro-1,4-phenylene, 2,3,5-trifluoro-1,4-phenylene, pyridine-2,5-diyl, 3-fluoropyridine-2,5-diyl, pyrimidine-2,5-diyl, pyridazine-3,6-diyl, naphthalene-2,6-diyl, tetrahydronaphthalene-2,6-diyl, fluorene-2,7-diyl, 9-methyl fluorene-2,7-diyl, 9,9-dimethyl fluorene-2,7-diyl, 9-ethyl fluorene-2,7-diyl, 9-fluoro fluorene-2,7-diyl, 9,9-difluoro fluorene-2,7-diyl, and divalent groups represented by the following Formulae (3-1) to (3-7). Here, in Formulae (3-1) to (3-7), * indicates an asymmetric carbon atom.

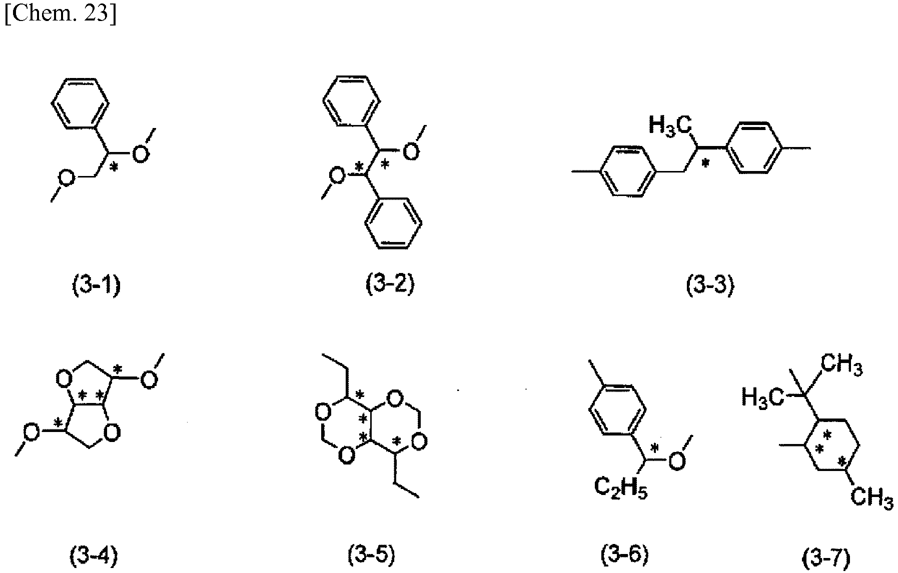

Regarding the configuration of 1,4-cyclohexylene and 1,3-dioxane-2,5-diyl, a trans configuration is preferable to a cis configuration. Since 2-fluoro-1,4-phenylene and 3-fluoro-1,4-phenylene are structurally the same, the latter is not shown. This rule also applies to a relationship between 2,5-difluoro-1,4-phenylene and 3,6-difluoro-1,4-phenylene.

Examples of a more preferable A¹ include 1,4-cyclohexylene, 1,4-cyclohexenylene, 1,3-dioxane-2,5-diyl, 1,4-phenylene, 2-fluoro-1,4-phenylene, 2,3-difluoro-1,4-phenylene, 2,5-difluoro-1,4-phenylene, and 2,6-difluoro-1,4-phenylene. Examples of a particularly preferable A include 1,4-cyclohexylene and 1,4-phenylene.

### • Bond group Z⁴

When the bond group Z⁴ of Compound (1) is a single bond, -(CH₂)₂-, -CH₂O-, -OCH₂-, -CF₂O-, -OCF₂-, or -(CH₂)₄-, and particularly, is a single bond, -(CH₂)₂-, -CF₂O-, -OCF₂-, or -(CH₂)₄-, the viscosity decreases. In addition, when the bond group Z⁴ is -CH=N-, -N=CH-, or -N=N-, a temperature range of a liquid crystal phase is wide. In addition, when the bond group Z is an alkyl group having about 4 to 10 carbon atoms, a melting point is lowered.

Examples of a preferable Z⁴ include a single bond, -(CH₂)₂-, -(CF₂)₂-, -COO-, -OCO-, -CH₂O-, -OCH₂-, -CF₂O-, -OCF₂-, -(CH₂)₄-, -(CH₂)₃O-, -O(CH₂)₃-, -(CH₂)₂COO-, -OCO(CH₂)₂-, -CONR₆-, and -NR₆CO- (R₆ is a hydrogen atom or an alkyl group having 1 to 6 carbon atoms).

Examples of a more preferable Z⁴ include a single bond, -(CH₂)₂-, -COO-, -OCO-, -CH₂O-, -OCH₂-, -CF₂O-, and -OCF₂-. Examples of a particularly preferable Z include a single bond, -(CH₂)₂-, -COO- and -OCO-.

Compound (1), may be optically active or optically inactive. When Compound (1) is optically active, Compound (1) may have an asymmetric carbon atom or may have axial asymmetry. The configuration of an asymmetric carbon atom may be R or S. The asymmetric carbon atom may be positioned in either R^{a1} or A¹. When the asymmetric carbon atom is included, the compatibility of Compound (1) is favorable. When Compound (1) has axial asymmetry, a twisting induction force is large. In addition, light fixation is inconsequential in any case.

As described above, when types of the terminal group R^{a1}, the ring structure A¹ and the bond group Z, and the number of rings are appropriately selected, it is possible to obtain a compound having desired physical properties.

Here, in Compound (1), m is an integer of 1 to 6.

### • Bond group R^{c}

In Compound (1), the bond group R^{c} is an alkylene group having 2 to 3 carbon atoms, and in the alkylene group, any -CH₂- except for -C-C- adjacent to Si is optionally substituted with -CO- or -COO-, -C-C- adjacent to Si is optionally substituted with -C-CR^{d}- and R^{d} is a halogen (Ha) or CHa₃.

Examples of a preferable R^{c} include -C-C-, -C-C-C-, -C-C-CO-, -C-C-CO-O-, -C-CF-CO-O-, and -C-CCF₃-CO-O-. A particularly preferable R^{c} is -C-C-.

• (R₁-O-)ⱼR₅₍₃₋ⱼ₎Si-

In (R₁-O-)ⱼR₅₍₃₋ⱼ₎Si- of Compound (1), R₁ is a hydrogen atom or an alkyl group having 1 to 5 carbon atoms. Examples of a preferable R₁ include a methyl group and an ethyl group. R₅ is a hydrogen atom or a linear or branched alkyl group having 1 to 8 carbon atoms. Examples of a preferable R₅ include a methyl group. j is an integer of 1 to 3. A preferable j is 3.

### • Method of producing a liquid crystal silane coupling agent

### (1) Obtaining a polymerizable compound

A polymerizable compound is obtained. Preferably, the polymerizable compound has a functional group at both ends. The bifunctional or higher polymerizable compound represented by the above Formula (1-1) may be used. It is preferable that a functional group be provided at both ends on the long side of the polymerizable compound because it is then possible to form a linear bond (crosslinking) using a coupling agent.

The polymerizable compound may be a bifunctional or higher polymerizable liquid crystal compound. For example, the following Formula (4-1) having a vinyl group at both ends can be exemplified.

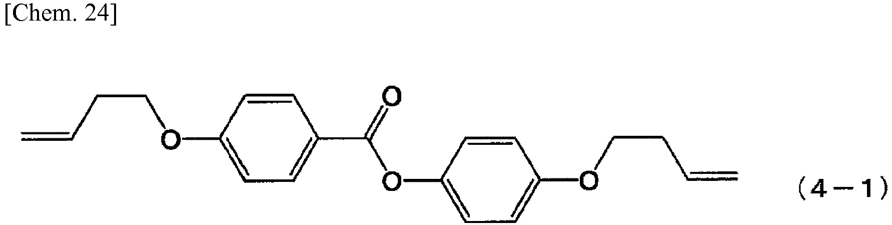

The polymerizable compound may be synthesized or a commercially available product may be purchased.

The polymerizable compound can be synthesized by combining methods known in the field of organic synthetic chemistry. A method of introducing a desired terminal group, ring structure and bond group into a starting material is described in books such as, for example, Houben-Wyle (Methods of Organic Chemistry, Georg Thieme Verlag, Stuttgart), Organic Syntheses (John Wily & Sons, Inc.), Organic Reactions (John Wily & Sons Inc.), Comprehensive Organic Synthesis (Pergamon Press), and New Experimental Chemistry Course (Maruzen). In addition, Japanese Patent No. 5084148 may be referred to.

### (2) Introducing a polymerizable group into any one end of the polymerizable compound

For example, a case in which an epoxy group is introduced as a polymerizable group will be described. In a reaction in which an epoxy group is introduced (epoxidized) into both ends of the above Formula (4-1), and the following Formula (4-4) is generated, when the reaction is stopped midway, the following Formulae (4-2) and (4-3) having an epoxy group at any one end can be obtained as an intermediate product. The generated following Formulae (4-2) and (4-3) can be obtained by dissolving in a solvent, performing separation using a separator, and then removing the solvent.

In this manner, a desired polymerizable group is introduced into any one end by removing the intermediate product.

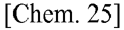

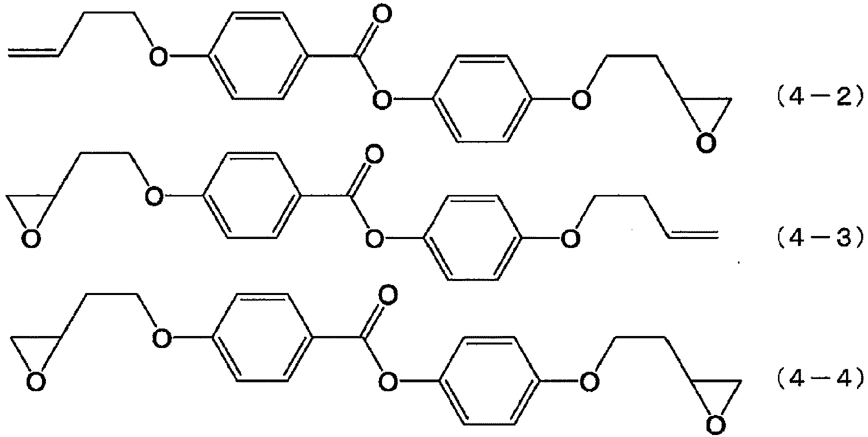

A solvent that removes the intermediate product may be any solvent in which the generated intermediate organism can be dissolved. Examples of the solvent include ethyl acetate, benzene, toluene, xylene, mesitylene, hexane, heptane, octane, nonane, decane, tetrahydrofuran, γ-butyrolactone, N-methyl pyrrolidone, dimethylformamide, dimethylsulfoxide, cyclohexane, methylcyclohexane, cyclopentanone, cyclohexanone, and PGMEA. The above solvents may be used alone, or two or more types thereof may be used in combination.

Here, there is little point in limiting a proportion of the solvent used. In consideration of solubility, solvent cost, energy cost, and the like, the proportion may be determined for each case.

### (3) Introducing Si into an unreacted end of the polymerizable compound

A silicon compound having an alkoxy group may be bonded to an unreacted end of the polymerizable compound.

For example, a trimethoxysilyl group may be introduced into an unreacted functional group (vinyl) side of the above Formulae (4-2) and (4-3). The following Formulae (5-1) and (5-2) may be referred to. Here, introduction of Si may be introduction of a triethoxysilyl group. However, regarding methoxysilane and ethoxysilane, methoxysilane that is highly reactive is preferable.

In addition, some methoxy or ethoxy groups may be substituted with a linear or branched alkyl group having 1 to 8 carbon atoms. For example, methyl, ethyl, n-propyl, i-propyl, n-butyl, s-butyl, t-butyl, and n-octyl groups may be exemplified.

It is not necessary to exhibit liquid crystallinity after Si is introduced. When a polymerizable organic moiety has a liquid crystal structure, after a Si moiety is bonded to an inorganic filler, it is possible to impart high thermal conductivity of a liquid crystalline compound and an effect of improving affinity with other polymerizable compounds to a surface of the inorganic filler.

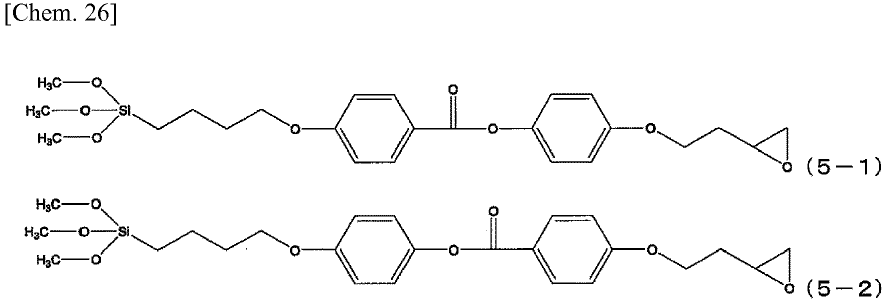

In the method of producing a liquid crystal silane coupling agent, as an example, in a polymerizable compound having a vinyl group at both ends, first, a vinyl group at one end is epoxidized, and next, Si is introduced into the other unreacted vinyl group for production. However, the production method is not limited thereto. Both ends of the polymerizable compound are not limited to a vinyl group as long as a polymerizable group and Si can be introduced.

In addition, while Si may be introduced into the above long chain compound using a hydrosilylation reaction, a liquid crystal silane coupling agent may be synthesized such that the left half and the right half of a long chain compound are first separately synthesized, Si is introduced into the left half using a hydrosilylation reaction, a polymerizable group is introduced into the right half, and the left half and the right half are then connected to each other.

As above, when the coupling agent and the polymerizable compound are appropriately selected, it is possible to connect the first inorganic filler and the second inorganic filler. It is possible to obtain a thermal expansion-controlling member having very high thermal conductivity and controllability of a thermal expansion coefficient from the composition for a thermal expansion-controlling member of the present invention. Here, the above functional groups are only examples, and the present invention is not limited to the above functional groups as long as effects of the present invention can be obtained.

### <<Thermal expansion-controlling member>>

A thermal expansion-controlling member of the present invention is obtained by molding a cured product by curing the composition for a heat dissipation member according to applications. The cured product has high thermal conductivity, and can have a negative thermal expansion coefficient or a very small positive thermal expansion coefficient, and has excellent chemical stability, heat resistance, hardness and mechanical strength. Here, the mechanical strength refers to a Young's modulus, tensile strength, tear strength, bending strength, flexural modulus of elasticity, impact strength, or the like.

The thermal expansion-controlling member is suitable for a heat dissipation plate, a heat dissipation sheet, a heat dissipation film, a heat dissipation adhesive, and a heat dissipation molded article.

Regarding conditions for procuring in which a composition for a thermal expansion-controlling material is cured according to thermal polymerization, a thermosetting temperature is in a range of room temperature to 350 °C, preferably in a range of room temperature to 250 °C, and more preferably in a range of 50 °C to 200 °C, and a curing time is in a range of 5 seconds to 10 hours, preferably in a range of 1 minute to 5 hours, and more preferably in a range of 5 minutes to 1 hour. After polymerization, preferably, gradual cooling is performed in order to reduce stress strain and the like. In addition, a reheating treatment may be performed to alleviate distortion and the like.

The thermal expansion-controlling member is formed from the composition for a thermal expansion-controlling member and used in the form of a sheet, a film, a thin film, a fiber, a molded article, or the like. A preferable form is a form of a plate, a sheet, a film or a thin film. Here, in this specification, a film thickness of a sheet is 1 mm or more, a film thickness of a film is 5 µm or more, preferably 10 to 500 µm, and more preferably 20 to 300 µm, and a film thickness of a thin film is less than 5 µm. The film thickness may be appropriately changed according to applications.

As described above, the laminate according to the first embodiment of the present invention is obtained by laminating the thermal expansion-controlling members, which includes at least two thermal expansion-controlling member layers with different thermal expansion coefficients.

Curing conditions (pressure, temperature, and time) in which a plurality of thermal expansion-controlling members are laminated according to thermal polymerization are the same as conditions when a single thermal expansion-controlling member layer is produced.

The thermal expansion coefficient of the thermal expansion-controlling member varies according to a proportion or type of an inorganic filler contained. That is, thermal expansion-controlling members having different compositional proportions of the inorganic filler have different thermal expansion coefficients.

For example, a laminate 30 shown in FIG. 5 is formed. In the laminate 30, a thermal expansion-controlling member 31 having a thermal expansion coefficient close to that of copper is set as a top layer, the thermal expansion coefficient continuously changes toward lower layers, and the thermal expansion coefficient of a bottom layer thermal expansion-controlling member 32 is adjusted to be closest to a thermal expansion coefficient of aluminum. This laminate 30 is disposed between a copper wiring 42 and an aluminum heat sink 43 of an electronic substrate 40 including a semiconductor device 41 shown in FIG. 6. In this manner, thermal distortion due to a difference between thermal expansion coefficients at an interface between the copper wiring 42 and the aluminum heat sink 43 is alleviated.

Here, in the laminate of the present invention, thermal expansion coefficients of thermal expansion-controlling members may be continuous or discontinuous. For example, as shown in FIG. 7, a laminate 30a in which thermal expansion-controlling members are laminated in the thickness direction such that thermal expansion coefficients thereof are positive (+), negative (-), positive, negative, positive, negative··· may be formed. In addition, a laminate 30b in which thermal expansion-controlling members are laminated in the horizontal direction instead of the thickness direction may be formed by cutting the laminate 30a in a direction of the arrow. When thermal expansion-controlling members having positive or negative thermal expansion coefficients are made adjacent, it is possible to control the thermal expansion coefficient so that the positive and negative thermal expansion coefficients can be cancelled out each other.

In addition, the laminate of the present invention may be formed by inserting a member other than the thermal expansion-controlling member between the thermal expansion-controlling members. Examples of a member other than the thermal expansion-controlling member include a highly thermally conductive ceramic substrate or graphite sheet (AlN, BN, Si₄N₃, artificial graphite sheet, and the like), a high strength ceramic substrate or metal plate (alumina, zirconia, titanium, stainless steel, and the like), and a metal with favorable electrical conductivity (silver copper, aluminum, and the like).

### [Electronic instrument]

An electronic instrument according to a second embodiment of the present invention includes the laminate according to the first embodiment and an electronic device including a heating unit. The laminate is disposed on the electronic device such that it comes in contact with the heating unit. The laminate is suitable for, for example, a heat dissipation board, a heat dissipation plate, a heat dissipation sheet, a heat dissipation film, a heat dissipation coating, and a heat dissipation adhesive.

Examples of the electronic device include a semiconductor device. The laminate of the present invention has high heat resistance, and strong insulation properties in addition to high thermal conductivity. Therefore, it is particularly effective for an insulated gate bipolar transistor (IGBT) which requires a more efficient heat dissipation mechanism for high power among semiconductor devices. An IGBT is one of semiconductor devices and is a bipolar transistor in which an MOSFET is incorporated in a gate part, and is used for power control. Examples of the electronic instrument including an IGBT include a main conversion element of a high power inverter, an uninterruptible power system, a variable voltage variable frequency control device of an AC motor, a control device of a railway vehicle, a hybrid vehicle, an electric transport device such as an electric vehicle, and an IH cooking device.

While a case in which, in the composition of the present invention, a first inorganic filler subjected to a coupling treatment and a second inorganic filler that is subjected to a coupling treatment and then additionally modified with a polymerizable compound are bonded to each other, a bond between the inorganic fillers is formed, and a thermal expansion-controlling member having high thermal conductivity has been described above, the present invention is not limited thereto. Of course, a second inorganic filler that is subjected to a coupling treatment and then additionally modified with a polymerizable compound and a first inorganic filler subjected to a coupling treatment are bonded to each other and thus a bond between the inorganic fillers may be formed.

In addition, the composition of the present invention may further contain a plurality of types of inorganic fillers such as third and fourth inorganic fillers. For example, a third inorganic filler having a different thermal expansion coefficient from the first inorganic filler and the second inorganic filler, which is a thermally conductive third inorganic filler bonded to one end of a coupling agent or a thermally conductive third inorganic filler bonded to one end of a coupling agent to which a polymerizable compound is bonded, may be further contained.

In addition, using only an inorganic filler that is subjected to a coupling treatment and then additionally modified with a polymerizable compound, polymerizable compounds are bonded to each other according to an appropriate polymerization initiator or the like, and a bond between the inorganic fillers may be formed.

That is, according to the thermal expansion-controlling member of the laminate of the present invention, in combining an inorganic material and an organic compound, a bond is formed between inorganic materials according to the organic compound, thermal conductivity is significantly improved, and additionally, a thermal expansion coefficient is controlled.

### Examples

The present invention will be described below in detail with reference to examples. However, the present invention is not limited to the details described in the following examples.

Materials constituting the thermal expansion-controlling member used in the examples of the present invention are as follows.

### <polymerizable liquid crystal compound>

- Liquid crystal epoxy compound: Compound represented by the following Formula (6-1) (commercially available from JNC)

The compound can be synthesized by a method described in Japanese Patent No. 5084148.

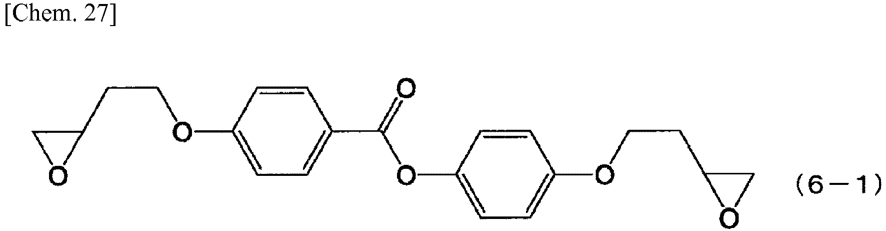

### <Inorganic fillers>

- Boron nitride: h-BN particles ((product name) PolarTherm PTX-25 commercially available from Momentive Performance Materials Japan)

### <Silane coupling agent>

- N-(2-aminoethyl)-3-aminopropyltrimethoxysilane ((product name) S320 commercially available from JNC: the following Formula (7-1))

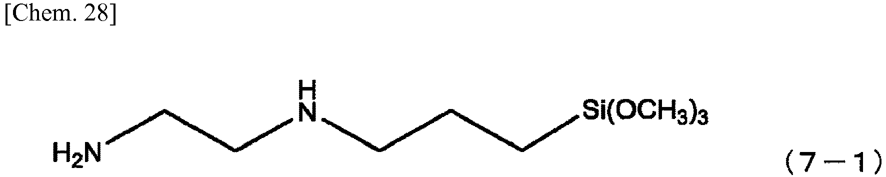

### <Curing agent>

- Amine curing agent: 4,4'-diamino-1,2-diphenylethane (commercially available from JNC)

### <Preparation of thermal expansion-controlling member>

A preparation example of a thermal expansion-controlling member will be described below.

### • Preparation boron nitride particles treated with a coupling agent

5.0 g of boron nitride particles (PTX25, hereinafter abbreviated as BN) and 0.75 g of N-(2-aminoethyl)-3-aminopropyltrimethoxysilane (S320) were added to 50 mL of toluene (anhydrous) and the mixture was stirred at 750 rpm for 1 hour using a stirrer. The obtained mixture was dried at 40 °C for 5 hours and at room temperature for 19 hours. In addition, after the solvent was dried, a heat treatment was performed using a vacuum dryer set at 125 °C under vacuum conditions for 5 hours.

BN particles modified with the coupling agent were transferred into a sample tube, 50 mL of THF (commercially available from Nacalai Tesque Inc.) was added thereto, and pulverization was then performed using an ultrasonic treatment device (MODEL450 commercially available from BRANSON). In addition, this solution was separated off and purified using a centrifuge (CT6E commercially available from Hitachi Koki Co., Ltd.) at 6,000 rpm for 10 minutes. After the supernatant solution was discarded, 50 mL of acetone was added thereto, and the same operation was performed twice. The modified BN particles after purification were dried in an oven at 60 °C for 24 hours. The obtained particles were used as the second inorganic filler (BN).

In the same manner as in the second inorganic filler (BN), aluminum nitride (H grade commercially available from Tokuyama Corporation) was treated with a silane coupling agent, and the obtained particles were used as the second inorganic filler (AlN).

In the same manner as in the second inorganic filler (BN), spherical alumina (TS-6(LV) commercially available from Tatsumori Ltd) was treated with a silane coupling agent, and the obtained particles were used as the second inorganic filler (Al₂O₃).

### [Example 1]

### <Preparation of sheet 1>

2 g and 4 g of the second inorganic filler (BN) and the liquid crystal epoxy compound (the compound represented by Formula (6-1)) were weighed out (content of BN particles was 19 volume%), respectively, on pharmaceutical paper, and mixed using a mortar, and kneading was then performed using two rollers (HR-3 commercially available from Nitto reactor) at 120 °C for 10 minutes. Then, separation and purification were performed through an ultrasonic treatment and centrifugation, and BN particles modified with the liquid crystal epoxy compound from which unreacted components were removed were obtained. The particles were used as a first inorganic filler.

A coating amount of the first inorganic filler and the second inorganic filler with respect to BN particles of a silane coupling agent or liquid crystal epoxy compound was calculated from a heating loss at 600 °C using a TG-DTA device (EXSTAR TG/DTA5200 commercially available from Seiko Instruments Inc.) (currently Hitachi High-Technologies Corporation)).

0.5972 g of the prepared second inorganic filler (BN) and 1.4812 g of the first inorganic filler were weighted out and mixed using an agate mortar. Then, the mixture was mixed using two rollers at 55 °C for 10 minutes. The weight ratio was calculated assuming that the numbers of NH groups (since the reactive group of S320 has one NH group and one NH₂ group, the number of NH groups is 3) of the second inorganic filler and epoxy rings of the first inorganic filler were 1:1.

The obtained mixture was inserted between stainless steel plates using a metal frame such that oxidization was not caused, pressing was performed to 9.8 MPa using a compression molding machine (F-37 commercially available from Shinto Metal Industry Corporation) set at 150 °C, a heated state continued for 15 minutes, and thus an alignment treatment and precuring were performed. That is, when a mixture was spread between the stainless steel plates, since BN particles were plate-like particles, alignment was performed such that the particles and the stainless steel plates were parallel to each other. Amounts of the metal frame and the sample were adjusted such that the thickness of the sample was about 100 µm. In this step, a proportion of BN particles in the solid content was 82 volume%. The pre-cured sample was used as a sheet 1 as a thermal expansion-controlling member.

### <Preparation of sheet 2>

0.218 g and 0.572 g of the second inorganic filler (AlN) and the first inorganic filler, respectively, were weighted out, and the same procedures to procuring were performed in the same manner as in the sheet 1. In this step, a proportion of BN in the solid content were 65 volume%, and a proportion of AlN was 18 volume%. The obtained sheet was used as a sheet 2 as a thermal expansion-controlling member.

### <Preparation of Example 1>

The sheet 1 and the sheet 2 were superimposed and laminated by pressing again, and pre-cured at 80 °C for 1 hour, and at 150 °C for 3 hours. Then, the obtained composite sheet was post-cured at 180 °C for 1 hour using a vacuum oven, and a desired laminate 1 of the thermal expansion-controlling member of the present invention was obtained.

### <Evaluation of thermal expansion coefficient>

A 5×20 mm test piece was cut out from the obtained sample, and a thermal expansion coefficient (measured by a TMA 7000 type thermomechanical analyzer commercially available from (currently) Hitachi High-Technologies Corporation) was obtained in a range of room temperature to 250 °C. A temperature range was appropriately adjusted according to a heat resistance of the sample to be measured.

### [Example 2]

In the same manner as in the sheet 2, a sheet with BN of 47 volume% and AlN of 41 volume% was prepared and used as a sheet 3. In addition, the sheet 2 and the sheet 3 were laminated and then cured. The obtained sheet was used as a laminate 2 of the thermal expansion-controlling member.

### [Example 3]

In the same manner as in the sheet 2, a sheet with BN of 65 volume% and Al₂O₃ of 18 volume% was prepared and used as a sheet 4. In addition, the sheet 1 and the sheet 4 were laminated and then cured. The obtained sheet was used as a laminate 3 of the thermal expansion-controlling member.

### [Example 4]

In the same manner as in the sheet 2, a sheet with BN of 43 volume% and Al₂O₃ of 46 volume% was prepared and used as a sheet 5. In addition, the sheet 4 and the sheet 5 were laminated and then cured. The obtained sheet was used as a laminate 4 of the thermal expansion-controlling member.

### [Example 5]

0.591 g, 0.084 g, and 0.024 g of the second inorganic filler (BN) prepared in the same manner as in Example 1, the liquid crystal epoxy compound (Formula (6-1), and an amine curing agent, respectively, were mixed using an agate mortar, and then kneading was performed at 55 °C for 10 minutes using two rollers so that the epoxy compound did not react in this step. The obtained mixture was pre-cured in the same manner as in the sheet 1. The obtained sample was used as a sheet 6. A proportion of BN in the sheet 6 was 75 volume%. That is, the sheet 6 differed from the sheet 1 in that, in a synthetic procedure, a curing agent was used in addition to a filler, a coupling agent, and an epoxy compound as in a composite material of a general epoxy resin and an inorganic filler.

The sheet 1 and the sheet 6 were superimposed and laminated and cured in the same manner as in Example 1. The obtained sample was used as a laminate 5 of the thermal expansion-controlling member.

### [Comparative Example 1]

A sample with a thickness twice that of the sheet 1 was prepared to obtain a monolayer article 1 and evaluated in the same manner as in Example 1. The result was used as Comparative Example 1.

### [Comparative Example 2]

A sample with a thickness twice that of the sheet 2 was prepared to obtain a monolayer article 2 and evaluated in the same manner as in Example 1. The result was used as Comparative Example 2.

### [Comparative Example 3]

A sample with a thickness twice that of the sheet 3 was prepared to obtain a monolayer article 3 and evaluated in the same manner as in Example 1. The result was used as Comparative Example 3.

### [Comparative Example 4]

A sample with a thickness twice that of the sheet 4 was prepared to obtain a monolayer article 4 and evaluated in the same manner as in Example 1. The result was used as Comparative Example 4.

### [Comparative Example 5]

A sample with a thickness twice that of the sheet 5 was prepared to obtain a monolayer article 5 and evaluated in the same manner as in Example 1. The result was used as Comparative Example 5.

### [Comparative Example 6]

A sample with a thickness twice that of the sheet 6 was prepared to obtain a monolayer article 6 and evaluated in the same manner as in Example 1. The result was used as Comparative Example 6.

The thermal expansion coefficients of the laminates of Examples 1 and 2 and the monolayer articles of Comparative Examples 1 to 3 in the planar direction are shown in Table 1.

### [Table 1]

**Table 1: Examples 1 and 2 and Comparative Examples 1 to 3**

| BN/AlN 2-layer | Thermal expansion coefficient (×10⁻⁶K⁻¹) | | | | | |
|---|---|---|---|---|---|---|
| | 100 to 120 °C | 120 to 140 °C | 140 to 160 °C | 160 to 180 °C | 180 to 200 °C | Average |
| Comparative Example 1/Monolayer article 1 (BN: 82 vol.%) | -3.073 | -3.714 | -4.756 | -5.154 | -5.092 | -4.358 |
| Example 1/Laminate 1 (BN: 82 vol.%) (BN: 65, AlN: 18) | -2.228 | -2.745 | -2.495 | -2.614 | -2.898 | -2.596 |
| Comparative Example 2/Monolayer article 2 (BN: 65, AlN: 18) | -0.904 | -2.164 | -1.970 | -2.568 | -2.303 | -1.982 |
| Example 2/Laminate 2 (BN:65, AlN: 18) (BN: 47, AlN: 41) | -0.382 | -0.336 | -0.435 | -0.829 | -1.359 | -0.668 |
| Comparative Example 3/Monolayer article 3 (BN: 47, AlN: 41) | 3.181 | 4.170 | 4.053 | 4.114 | 4.007 | 3.905 |

By comparing Example 1, Comparative Example 1, and Comparative Example 2, the laminate 1 of Example 1 had an intermediate thermal expansion coefficient of the monolayer articles before lamination and a smaller variation in the value than the monolayer articles. This is thought to be caused by the fact that two types of sheets with different thermal expansion coefficients were combined, and thus intermediate characteristics of the sheets were exhibited. In addition, in Example 2, sheets with significantly different thermal expansion coefficients like Comparative Example 2 and Comparative Example 3 were attached to each other, and when only the laminate was heated on a hot plate, warping to the sheet side (on the side in which a compositional proportion of BN was large) with a smaller thermal expansion coefficient was observed. This indicates that graded materials with different thermal expansion coefficients were on the front and back sides. For example, using the technique of the present invention, a substrate including one side having a thermal expansion coefficient close to that of a semiconductor and the other side having a thermal expansion coefficient of a metal electrode was prepared, and used as an insulating substrate to which such components were attached, it was possible to alleviate stress on an adhesive surface of the components due to thermal distortion in a module to which semiconductor components were attached. While a two-layer laminate was prepared in this example, by providing more layers and gently alleviating the thermal expansion coefficient, it was possible to prevent stress concentration, and it was possible to prolong the lifespan of semiconductor components.

### [Example 2]

In the same manner as in the sheet 2, a sheet with BN of 47 volume% and AIN of 41 volume% was prepared and used as the sheet 3. In addition, the sheet 1 and the sheet 3 were laminated and then cured. The obtained sheet was used as the laminate 2 of the thermal expansion-controlling member.

The thermal expansion coefficients of the laminates of Examples 3 and 4 and the monolayer articles of Comparative Examples 1, and 4 and 5 in the planar direction are shown in Table 2.

### [Table 2]

**Table 2: Examples 3 and 4 and Comparative Examples 1, and 4 and 5**

| BN/Al₂O₃ 2-layer | Thermal expansion coefficient (×10⁻⁶K⁻¹) | | | | | |
|---|---|---|---|---|---|---|
| | 100 to 120 °C | 120 to 140 °C | 140 to 160 °C | 160 to 180 °C | 180 to 200 °C | Average |
| Comparative Example 1/Monolayer article 1 (BN: 82 vol.%) | -3.073 | -3.714 | -4.756 | -5.154 | -5.092 | -4.358 |
| Example 3/Laminate 3 (BN: 82 vol.%) (BN: 65, Al₂O₃: 18) | 0.489 | -0.130 | -0.598 | -1.884 | -2.856 | -0.996 |
| Comparative Example 4/Monolayer article 4 (BN: 65, Al₂O₃: 18) | 2.477 | 1.269 | 0.518 | 0.764 | 0.371 | 1.080 |
| Example 4/Laminate 4 (BN:65, Al₂O₃: 18) (BN: 43, Al₂O₃46) | 3.417 | 4.209 | 4.006 | 3.884 | 3.618 | 3.827 |
| Comparative Example 5 (BN: 43, Al₂O₃: 46) | 4.169 | 4.931 | 5.030 | 5.173 | 5.400 | 4.941 |

Based on Table 2, it was found that, even if an alumina was used, the same lamination effect as in the case in which aluminum nitride was used was exhibited. Although aluminum nitride has favorable thermal conductivity, it has weaker water resistance than an oxide filler. For components used in a place with a high water content, a laminated sheet having the same function as an oxide is preferably prepared.

The thermal expansion coefficients of the laminate of Example 5 and the monolayer articles of Comparative Examples 1 and 6 in the planar direction are shown in Table 3.

### [Table 3]

**Table 3: Example 5 and Comparative Examples 1 and 6**

| Curing agent With/Without | Thermal expansion coefficient (×10⁻⁶K⁻¹) | | | | | |
|---|---|---|---|---|---|---|
| | 100 to 120 °C | 120 to 140 °C | 140 to 160 °C | 160 to 180 °C | 180 to 200 °C | Average |
| Comparative Example 1/Monolayer article 1 without curing agent (BN: 82 vol.%) | -3.703 | -3.714 | -4.756 | -5.154 | -5.092 | -4.484 |
| Example 5/Laminate 5 (BN: 82 vol.%) (BN: 75 vol.%) | -1.825 | -0.273 | 0.905 | 1.718 | 2.508 | 0.607 |
| Comparative Example 6/Monolayer article 6 with curing agent (BN: 75 vol.%) | -1.007 | 0.833 | 3.583 | 5.060 | 6.595 | 3.013 |

Comparative Example 6 is a sheet prepared using a technique in which the same material as in Example 1 such as a polymerizable compound was used, and a general epoxy resin and a ceramic filler were combined using an amine curing agent. In the method of Comparative Example 1, a glass transition temperature was not observed from room temperature to 250 °C and a sheet having a negative thermal expansion coefficient in the surface direction can be prepared. However, when a curing agent was used for combining as in Comparative Example 6, a glass transition point appeared, and an inflection point of thermal expansion occurred between 120 and 140 °C.

The sheet of Example 5 exhibited intermediate characteristics of the sheets of Comparative Example 1 and Comparative Example 6. However, for example, in the case in which a metal component having no glass transition point and a resin component were bonded, such a configuration was thought to be desirable.

Based on such results, it can be understood that it is possible to realize a graded material that can alleviate thermal distortion in a substrate using the present invention.

All references including publications, patent applications, and patents cited in this specification are referred to and incorporated herein to the same extent as if the references were individually exemplified, referred to and incorporated, and all details thereof are described herein.

The use of nouns and corresponding demonstratives in the context of describing the present invention (especially in the context of the following claims) is to be construed to cover both the singular and the plural unless otherwise specified herein or otherwise clearly contradicted by context. The terms "comprise," "include," "contain," and "have" are interpreted as open-ended terms (that is, to mean "includes, but is not limited to") unless otherwise noted. Unless otherwise specified in this specification, the numerical ranges of objects in this specification are merely intended to serve as abbreviations for individually indicating values falling within the ranges, and the values are incorporated in this specification as if they were individually recited herein. All methods described herein can be performed in any appropriate order unless otherwise described herein or otherwise clearly contradicted by context. Unless otherwise claimed, any example or exemplary phrase (for example, "such as") used herein is intended merely to better describe the present invention and is not intended to limit the scope of the present invention. Terms in this specification should not be construed to indicate elements that are essential for the implementation of the present invention but are not described in the claims.

This specification includes the best means for implementing the present invention known to the inventors and preferable embodiments of the present invention have been described. Those skilled in the art will clearly understand modifications of such preferable embodiments that may be made upon reading the above description. The inventors expect such skilled people to appropriately apply such modifications and assume that the present invention will be implemented using methods other than those specifically described herein. Accordingly, the present invention includes all modifications and equivalents of content described in the claims appended to this specification as allowed by applicable law. Moreover, the present invention encompasses any combination of the above elements in all of the modifications unless otherwise described herein or clearly contradicted by the context.

### [Reference Signs List]

1 First inorganic filler
2 Second inorganic filler
11 First silane coupling agent
12 Second silane coupling agent
13 First silane coupling agent, heat resistant silane coupling agent
21 Polymerizable compound, polymerizable liquid crystal compound
30, 30a, 30b Laminate
31, 32 Thermal expansion-controlling member
40 Electronic substrate
41 Semiconductor device
42 Copper wiring
43 Aluminum heat sink

## Claims

1. A laminate comprising at least two layers of a thermal expansion-controlling member,
wherein the thermal expansion-controlling member comprises
a thermally conductive first inorganic filler that is bonded to one end of a first coupling agent; and
a thermally conductive second inorganic filler that is bonded to one end of a second coupling agent,
wherein, in the thermal expansion-controlling member, the other end of the first coupling agent and the other end of the second coupling agent are bonded to a polymerizable compound,
or, in the thermal expansion-controlling member, the other end of the first coupling agent and the other end of the second coupling agent are bonded to each other, and
wherein the thermal expansion-controlling members each have different thermal expansion coefficients.

2. The laminate according to claim 1,
wherein each layer of the thermal expansion-controlling member layers is laminated in a thickness direction or horizontal direction.

3. The laminate according to claim 1 or 2,
wherein the first inorganic filler and the second inorganic filler are a nitride, a metal oxide, a silicate compound, or a carbon material.

4. The laminate according to claim 3,
wherein the first inorganic filler and the second inorganic filler are at least one selected from the group consisting of boron nitride, aluminum nitride, boron carbide, boron carbonitride, graphite, carbon fibers, carbon nanotubes, alumina, and cordierite.

5. The laminate according to any one of claims 1 to 4,
wherein the thermal expansion-controlling member further comprises a third inorganic filler having a thermal expansion coefficient different from those of the first inorganic filler and the second inorganic filler.

6. The laminate according to any one of claims 1 to 5,
wherein the thermal expansion-controlling member further comprises an organic compound or a polymer compound that is not bonded to the first inorganic filler or the second inorganic filler.

7. The laminate according to any one of claims 1 to 6,
wherein the polymerizable compound before bonding is at least one of bifunctional or higher polymerizable liquid crystal compounds represented by the following Formula (1-1):
R^{a}-Z(A-Z)ₘ-R^{a} ··· (1-1)
in Formula (1-1),
R^{a} independently represents a functional group that can be bonded to a functional group of the other end of a first coupling agent and a second coupling agent;
A is 1,4-cyclohexylene, 1,4-cyclohexenylene, 1,4-phenylene, naphthalene-2,6-diyl, tetrahydronaphthalene-2,6-diyl, fluorene-2,7-diyl, bicyclo[2.2.2]oct-1,4-diyl, or bicyclo[3.1.0]hex-3,6-diyl,
in these rings, any -CH₂- is optionally substituted with -O-, any -CH= is optionally substituted with -N=, and any hydrogen atom is optionally substituted with a halogen atom, an alkyl group having 1 to 10 carbon atoms, or an alkyl halide having 1 to 10 carbon atoms,
in the alkyl group, any -CH₂- is optionally substituted with -O-, -CO-, -COO-, -OCO-, -CH=CH-, or -C≡C-;
Z independently represents a single bond or an alkylene group having 1 to 20 carbon atoms,
in the alkylene group, any -CH₂- is optionally substituted with -O-, -S-, -CO-, -COO-, -OCO-, -CH=CH-, -CF=CF-, -CH=N-, -N=CH-, -N=N-, -N(O)=N-, or -C≡C-, and any hydrogen atom is optionally substituted with a halogen atom;
m is an integer of 1 to 6.

8. The laminate according to claim 7,
wherein, in Formula (1-1), A is 1,4-cyclohexylene, 1,4-cyclohexylene in which any hydrogen atom is substituted with a halogen atom, 1,4-phenylene, 1,4-phenylene in which any hydrogen atom is substituted with a halogen atom or a methyl group, fluorene-2,7-diyl, or fluorene-2,7-diyl in which any hydrogen atom is substituted with a halogen atom or a methyl group.

9. The laminate according to claim 7 or 8,
wherein, in Formula (1-1), Z is a single bond, -(CH₂)ₐ-, -O(CH₂)ₐ-, -(CH2)aO-, -O(CH₂)ₐO-, -CH=CH-, -C≡C-, -COO-, -OCO-, -CH=CH-COO-, -OCO-CH=CH-, -CH₂CH₂-COO-, -OCO-CH₂CH₂-, -CH=N-, -N=CH-, -N=N-, -OCF₂- or -CF₂O-, and a is an integer of 1 to 20.

10. The laminate according to any one of claims 7 to 9,
wherein, in Formula (1-1), R^{a} independently represents polymerizable groups having the following Formulae (2-1) and (2-2), cyclohexene oxide, phthalic anhydride, or succinic anhydride: 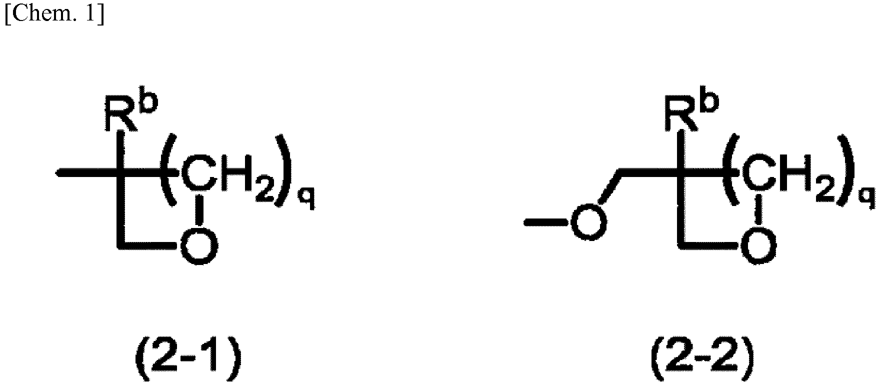 in Formulae (2-1) and (2-2), R^{b} is a hydrogen atom, a halogen atom, -CF₃, or an alkyl group having 1 to 5 carbon atoms, and q is 0 or 1.

11. An electronic instrument comprising:
the laminate according to any one of claims 1 to 10; and
an electronic device having a heating unit,
wherein the laminate is disposed on the electronic device such that it comes in contact with the heating unit.

12. A method of producing a laminate comprising:
a coating process A of applying a composition A comprising a thermally conductive first inorganic filler bonded to one end of a first coupling agent and a thermally conductive second inorganic filler bonded to one end of a second coupling agent;
a coating process B of applying a composition B, wherein a compositional ratio of inorganic fillers of the composition B is different from that of the composition A;
a curing process of curing a coating of the composition A and a coating of the composition B; and
a laminating process of laminating the cured coating of the composition A and the cured coating of the composition B,
wherein, according to the curing process, the other end of the first coupling agent and the other end of the second coupling agent are bonded to a bifunctional or higher polymerizable compound, or
the other end of the first coupling agent and the other end of the second coupling agent are bonded to each other.
